(19)

Europäisches
Patentamt
European
Patent Office
Office européen
des brevets

(11)  **EP 4 435 400 A1**

(12)  **EUROPEAN PATENT APPLICATION**

(43) Date of publication:
**25.09.2024  Bulletin 2024/39**

(21) Application number: **23193871.3**

(22) Date of filing: **29.08.2023**

(51) International Patent Classification (IPC):
**G01M 5/00** (2006.01)     **G08G 1/00** (2006.01)

(52) Cooperative Patent Classification (CPC):
**G01M 5/0008; G01M 5/0033; G01M 5/0066; G08G 1/00**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority:  **22.03.2023  JP 2023045148**

(71) Applicant: **KABUSHIKI KAISHA TOSHIBA**
**Minato-ku**
**Tokyo 105-0023 (JP)**

(72) Inventors:
• USUI, Takashi
  **Minato-ku, Tokyo, 105-0023 (JP)**
• TAKAMINE, Hidefumi
  **Minato-ku, Tokyo, 105-0023 (JP)**
• WATABE, Kazuo
  **Minato-ku, Tokyo, 105-0023 (JP)**

(74) Representative: **Hoffmann Eitle**
**Patent- und Rechtsanwälte PartmbB**
**Arabellastraße 30**
**81925 München (DE)**

(54)  **STRUCTURE EVALUATION SYSTEM AND STRUCTURE EVALUATION METHOD**

(57)     According to one embodiment, a structure evaluation system according to an embodiment includes a plurality of first sensors, one or more second sensors, a vehicle information estimator, and an evaluator. The plurality of first sensors detect elastic waves generated from the inside of a structure on which a vehicle travels. The one or more second sensors detect passage of the vehicle without depending on damage in the structure. The vehicle information estimator estimates vehicle information including at least information of the number of vehicles passing on the structure on the basis of detection results from the one or more second sensors. The evaluator evaluates a deterioration state of the structure on the basis of a plurality of elastic waves detected by the plurality of first sensors and the vehicle information estimated by the vehicle information estimator.

FIG. 1

EP 4 435 400 A1

**Description**

FIELD

Embodiments described herein relate generally to a structure evaluation system and a structure evaluation method.

BACKGROUND

Elastic waves generated in a structure such as a bridge can be detected by installing a sensor on the surface of the structure. By installing a plurality of sensors on the surface of the structure, a position of a source of elastic waves (hereinafter referred to as an "elastic wave source") can be located on the basis of differences in arrival time between the elastic waves detected by the sensors. Elastic waves are also generated in the structure when an impact is externally applied to the surface of the structure. In this case, a position of an elastic wave source can be located on the basis of the differences in arrival time between the elastic waves detected by the sensors.

When there is damage in a propagation path of an elastic wave in a structure, propagation of the elastic wave can be hindered. When propagation of an elastic wave is hindered due to damage in the structure, some sensors cannot detect an elastic wave. As a result, accuracy of a location result of an elastic wave source decreases. When a spatially uniform impact such as collision of raindrops with a road surface at the time of rainfall is applied to the surface of the structure and elastic waves are detected by the sensors installed on an opposite surface thereof, a density of elastic wave sources in an area having damage therein is observed with a decrease. A deterioration state of a structure (whether there is damage in the structure) can be evaluated using such characteristics. Particularly, damage in the structure can be detected using elastic waves generated due to vehicles traveling on a road surface.

In the related art, various correction methods for improving accuracy of evaluation results obtained using the aforementioned technique have been proposed. For example, techniques of correcting an elastic wave source density using a correction value based on a ratio of the number of passing vehicles obtained from a structure which is a comparison object to the actual number of passing vehicles by estimating information on vehicles traveling in a place to be measured for the purpose of comparison between measurement results with different traffic volumes have been proposed. However, in such techniques, since the number of vehicles is estimated on the basis of whether elastic waves have been detected, measurement accuracy of the number of vehicles decreases when damage in the structure is intense. As a result, accuracy of a correction value used to improve accuracy of evaluation results may decrease and thus evaluation accuracy of a deterioration state of the structure may decrease.

BRIEF DESCRIPTION OF THE DRAWINGS

FIG. 1 is a diagram illustrating a configuration of a structure evaluation system according to a first embodiment.
FIG. 2 is a diagram illustrating an example of a configuration of a signal processor according to the first embodiment.
FIG. 3 is a diagram illustrating arrangement of sensors according to the first embodiment.
FIG. 4 is a diagram illustrating a method of measuring elastic waves according to the first embodiment.
FIG. 5 is a diagram illustrating a method of detecting passage of a vehicle in a second sensor according to the first embodiment.
FIG. 6 is a sequence diagram illustrating a sequence of a process of evaluating a deterioration state which is performed by the structure evaluation system according to the first embodiment.
FIG. 7 is a diagram illustrating a process of estimating the number of vehicles which is performed by a vehicle information estimator according to the first embodiment.
FIG. 8 is a diagram illustrating a configuration of a structure evaluation system according to a second embodiment.
FIG. 9 is a diagram illustrating an example of a feature which is extracted from an output signal of a second sensor.
FIG. 10 is a sequence diagram illustrating a sequence of a process of evaluating a deterioration state which is performed by the structure evaluation system according to the second embodiment.
FIG. 11 is a flowchart illustrating a process of estimating a vehicle type which is performed by a vehicle information estimator according to the second embodiment.
FIG. 12 is a diagram illustrating a configuration of a structure evaluation system according to a third embodiment.
FIG. 13 is a diagram illustrating a vehicle speed estimating method.

DETAILED DESCRIPTION

The present invention provides a problem to be solved by the present invention is to provide a structure evaluation system and a structure evaluation method that can accurately estimate the number of vehicles without depending on damage in a structure and evaluate a deterioration state of the structure.

According to one embodiment, a structure evaluation system according to an embodiment includes: a plurality of first sensors, one or more second sensors, a vehicle information estimator, and an evaluator. The plurality of first sensors detect elastic waves generated from the inside of a structure on which a vehicle travels. The one or more second sensors detect passage of the vehicle without depending on damage in the structure. The vehicle information estimator estimates vehicle information including at least information of the number of vehicles passing on the structure on the basis of detection results from the one or more second sensors. The evaluator evaluates a deterioration state of the structure on the basis of a plurality of elastic waves detected by the plurality of first sensors and the vehicle information estimated by the vehicle information estimator.

Hereinafter, a structure evaluation system and a structure evaluation method according to embodiments will be described with reference to the accompanying drawings.

(First embodiment)

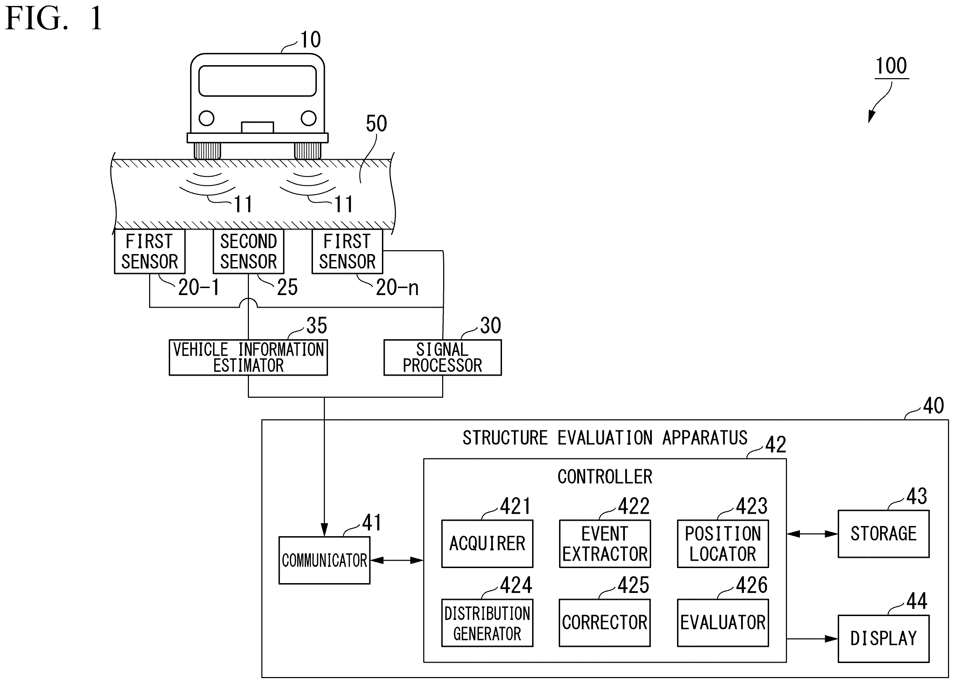

FIG. 1 is a diagram illustrating a configuration of a structure evaluation system 100 according to a first embodiment. The structure evaluation system 100 is used to evaluate soundness of a structure 50. In the following description, evaluation means that a degree of soundness of the structure 50, that is, a deterioration state of the structure 50, is determined on the basis of a certain criterion.

In the following description, it is assumed that the structure 50 is a bridge, but the structure 50 is not limited to a bridge. The structure 50 is not particularly limited as long as it is a structure in which elastic waves 11 are generated with formation or propagation of cracks or external impacts (for example, rainfall or artificial rainfall). The bridge is not limited to a structure constructed over a river, a valley, or the like and may include various structures provided above the ground surface (for example, viaducts of an expressway).

An example of damage affecting evaluation of a deterioration state of the structure 50 is damage in the structure hindering propagation of elastic waves 11 such as cracks, voids, and sand granulation. Cracks include cracks in the vertical direction, cracks in the horizontal direction, and cracks in oblique directions. The cracks in the vertical direction are cracks which are generated in a direction perpendicular to a road surface. The cracks in the horizontal direction are cracks which are generated in a direction parallel to the road surface. The cracks in the oblique directions are cracks which are generated in directions other than the directions parallel to and perpendicular to the road surface. The sand granulation is deterioration in which concrete changes into sand granules at a boundary between asphalt and concrete of a floor slab.

The structure evaluation system 100 includes a plurality of first sensors 20-1 to 20-n (where n is an integer equal to or greater than 2), a second sensor 25, a signal processor 30, a vehicle information estimator 35, and a structure evaluation apparatus 40. The plurality of first sensors 20-1 to 20-n and the signal processor 30 are communicatively connected to each other in a wired manner. The second sensor 25 and the vehicle information estimator 35 are communicatively connected to each other in a wired manner. The signal processor 30 and the structure evaluation apparatus 40 are communicatively connected to each other in a wired or wireless manner, and the vehicle information estimator 35 and the structure evaluation apparatus 40 are communicatively connected to each other in a wired or wireless manner. In the following description, the first sensors 20-1 to 20-n are referred to as first sensors 20 when they are not distinguished.

When a vehicle 10 passes on the structure 50 as illustrated in FIG. 1, a load is applied to a road surface with a contact of a traveling unit of the vehicle 10 with the road surface. A plurality of elastic waves 11 are generated in the structure 50 due to flexure based on the load. The first sensors 20 installed on the bottom surface of the structure 50 can detect the elastic waves 11 generated in the structure 50.

Each first sensor 20 includes a piezoelectric element and detects elastic waves 11 generated from the inside of the structure 50. The first sensors 20 are installed at positions at which elastic waves 11 can be detected on the surface of the structure 50. For example, the first sensors 20-1 to 20-n are installed on one of a road surface, a side surface, and a bottom surface at the same intervals or different intervals in a vehicle traveling axis direction and a vehicle traveling axis crossing direction. The vehicle traveling axis direction is a direction in which a vehicle travels on the road surface. The vehicle traveling axis crossing direction is a direction perpendicular to the vehicle traveling axis direction. The first sensors 20 convert the detected elastic waves 11 to electrical signals. In the following description, it is assumed that the first sensors 20 are installed on the bottom surface of the structure 50.

Each first sensor 20 employs, for example, a piezoelectric element having sensitivity in a range of 10 kHz to 1 MHz. The first sensor 20 may be of a resonance type having a resonance peak in a frequency range, a wide band type in which resonance is curbed, or the like, and the type of the first sensor 20 may be any one thereof. The method with which the first sensor 20 detects elastic waves 11 may be of a voltage output type, a resistance change type, a capacitance type, or the like, and any detection method thereof may be used.

Acceleration sensors may be used instead of the first sensors 20. In this case, each acceleration sensor detects elastic waves 11 generated in the structure 50. Then, the acceleration sensor converts the detected elastic waves 11 to electrical signals by performing the same processing as the first sensor 20.

For example, an amplifier, a filter, and an analog-digital converter which are not illustrated are provided between the first sensors 20 and the signal processor 30. The amplifier amplifies the electrical signals output from the first sensors 20. The amplifier amplifies the electrical signals, for example, such that they can be processed by the analog-digital converter. The amplifier outputs the amplified electrical signals to the filter. The filter removes noise components outside of a predetermined band. The filter is, for example, a band-pass filter (BPF). The electrical signals from which noise has been removed by the filter are input to the analog-digital converter. The analog-digital converter quantizes the electrical signals from which noise has been removed and converts the resultant electrical signals to digital signals. The analog-digital converter outputs the digital signals to the signal processor 30.

The signal processor 30 receives the digital signals output from the analog-digital converter as an input. The signal processor 30 performs signal processing on the input digital signals. The signal processing performed by the signal processor 30 includes, for example, noise reduction and elastic wave feature extraction. The signal processor 30 generates transmission data including the digital signals subjected to the signal processing. The signal processor 30 outputs the generated transmission data to the structure evaluation apparatus 40.

The signal processor 30 is constituted by an analog circuit or a digital circuit. When the signal processor 30 is constituted by an analog circuit, the analog-digital converter may not be provided between the first sensors 20 and the signal processor 30. When the signal processor 30 is constituted by an analog circuit, an electrical signal from which noise has been removed by the filter is input to the signal processor 30. The digital circuit is realized by, for example, a field-programmable gate array (FPGA) or a microcomputer. The digital circuit may be realized by a dedicated large-scale integration circuit (LSI). A nonvolatile memory such as a flash memory or a removable memory may be mounted in the signal processor 30. In the following description, it is assumed that the signal processor 30 is constituted by a digital circuit.

The second sensor 25 detects passage of a vehicle 10 regardless of damage in the structure 50. For example, the second sensor 25 is a magnetic sensor that directly or indirectly detects a magnetic field intensity or a magnetic flux density as an electrical signal. Examples of the magnetic sensor include a magnetic impedance element, a magneto-resistive sensor, a Hall element, a fluxgate sensor, a GHz-Spin-Rotation (GSR) sensor, and a coil. The second sensor 25 is not particularly limited as long as it has sensitivity with which a change in a magnetic flux density on an installation surface generated can be detected by a vehicle 10 passing on the structure 50. The second sensor 25 is installed on the same surface as the first sensors 20. More specifically, the second sensor 25 is installed in a range surrounded by the plurality of first sensors 20-1 to 20-n.

In general, since many metallic components are used in a vehicle 10, surrounding geomagnetism is disturbed due to passage of the vehicle 10 on the structure 50. Accordingly, the second sensor 25 can detect change in a magnetic flux density which is caused due to passage of a vehicle. When a vehicle 10 travels on the structure 50, it is known that change in a magnetic flux density equal to or greater than about 100 nanoteslas (nT) is caused. Accordingly, the second sensor 25 requires a resolution capable of detecting sufficiently smaller change in a magnetic flux density than 100 nT. A magnetic impedance element with a resolution of several nT order is suitable in view of sensitivity. The second sensor 25 outputs a detection result as an output signal to the vehicle information estimator 35. The output signal of the second sensor 25 is time-series data indicating change in a magnetic flux density.

For example, an amplifier, a filter, and an analog-digital converter which are not illustrated are provided between the second sensor 25 and the vehicle information estimator 35. The amplifier amplifies the output signal of the second sensor 25. The amplifier outputs the amplified output signal to the filter. The filter has a predetermined passband (for example, a passband in a range of 0.1 Hz to 10 Hz). Accordingly, the filter removes noise components outside of the predetermined band. The filter is, for example, a band-pass filter (BPF). The output signal from which noise has been removed by the filter is converted to a digital signal by the analog-digital converter and is input to the vehicle information estimator 35. The analog-digital converter may be provided in the vehicle information estimator 35. In this case, the output signal from which noise has been removed by the filter is input to the vehicle information estimator 35 and is converted to a digital signal in the vehicle information estimator 35. In the following description, it is assumed that the output signal output from the second sensor 25 or the output signal of the second sensor 25 is a signal from which noise has been removed by the filter and which has been converted to a digital signal by the analog-digital converter.

The vehicle information estimator 35 receives an output signal (for example, time-series data of the change in a magnetic flux density) output from the second sensor 25 as an input. The vehicle information estimator 35 estimates vehicle information on the basis of the input output signal. That is, the vehicle information estimator 35 estimates the vehicle information on the basis of the output signal of the second sensor 25. The vehicle information is information on a vehicle 10 passing on the structure 50 and includes, for example, at least information of the number of vehicles 10 passing on the structure 50 (hereinafter referred to as "passing vehicle number information"). The vehicle information may further include one of a vehicle type, a vehicle length, a vehicle weight, and a vehicle speed of each vehicle 10 passing on the structure 50. In the first embodiment, it is assumed that the vehicle information includes the passing vehicle number information. The vehicle information estimator 35 outputs an estimation result to the structure evaluation apparatus 40.

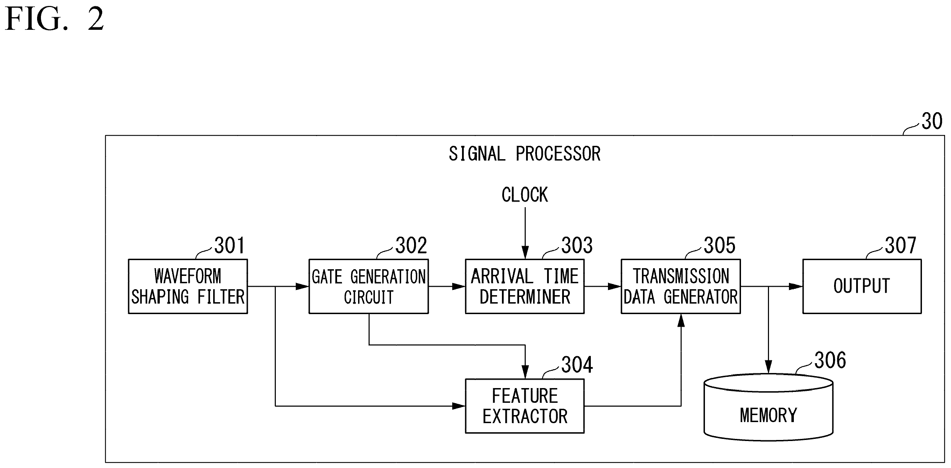

FIG. 2 is a diagram illustrating an example of a configuration of the signal processor 30 according to the first embodiment. The signal processor 30 includes a waveform shaping filter 301, a gate generation circuit 302, an arrival time determiner 303, a feature extractor 304, a transmission data generator 305, a memory 306, and an output 307.

The waveform shaping filter 301 removes noise components outside of a predetermined band from the input digital signal. The waveform shaping filter 301 is, for example, a digital band-pass filter (BPF). The waveform shaping filter 301 outputs a digital signal from which noise components have been removed (hereinafter referred to as a "noise-removed signal") to the gate generation circuit 302 and the feature extractor 304.

The gate generation circuit 302 receives the noise-removed signal output from the waveform shaping filter 301 as an input. The gate generation circuit 302 generates a gate signal on the basis of the input noise-removed signal. The gate signal is a signal indicating whether a waveform of the noise-removed signal is sustained.

The gate generation circuit 302 is realized by, for example, an envelope detector and a comparator. The envelope detector detects an envelope of the noise-removed signal. The envelope is extracted, for example, by squaring the amplitude of the noise-removed signal and performing a predetermined process (for example, a process using a low-pass filter or Hilbert transformation) on the squared output value. The comparator determines whether the envelope of the noise-removed signal is equal to or greater than a predetermined threshold value.

When the envelope of the noise-removed signal is equal to or greater than the predetermined threshold value, the gate generation circuit 302 outputs a first gate signal indicating that the waveform of the noise-removed signal is sustained to the arrival time determiner 303 and the feature extractor 304. On the other hand, when the envelope of the noise-removed signal is less than the predetermined threshold value, the gate generation circuit 302 outputs a second gate signal indicating that the waveform of the noise-removed signal is not sustained to the arrival time determiner 303 and the feature extractor 304. A configuration in which the gate generation circuit 302 determines whether the waveform of the noise-removed signal is sustained on the basis of the envelope has been described above, but the gate generation circuit 302 may perform a process on the noise-removed signal or a signal employing the absolute value thereof. The threshold value used to generate the gate signal is referred to as a measurement threshold value.

The arrival time determiner 303 receives a clock output from a clock source such as a quartz oscillator which is not illustrated and the gate signal output from the gate generation circuit 302 as inputs. The arrival time determiner 303 determines an elastic wave arrival time using the clock which is input while the first gate signal is being input. The arrival time determiner 303 outputs the determined elastic wave arrival time as time information to the transmission data generator 305. The arrival time determiner 303 does not perform the process while the second gate signal is being input. The arrival time determiner 303 generates cumulative time information after a power-on timing on the basis of a signal from the clock source. Specifically, the arrival time determiner 303 may be a counter for counting edges of a clock, and the value of a register of the counter may be used as time information. The register of the counter is determined to have a predetermined bit length.

The feature extractor 304 receives the noise-removed signal output from the waveform shaping filter 301 and the gate signal output from the gate generation circuit 302 as inputs. The feature extractor 304 extracts features of the noise-removed signal using the noise-removed signal which is input while the first gate signal is being input. The feature extractor 304 does not perform the process while the second gate signal is being input. The features are information indicating features of the noise-removed signal. That is, features of the noise-removed signal are features of elastic waves detected by the first sensors 20.

Examples of the features include amplitude [mV] of a waveform, an ascending time [$\mu$sec] of a waveform, a sustainment time [$\mu$sec] of a gate signal, a zero-cross count [times], and energy [arb.], a frequency [Hz], and a root mean square (RMS) value of a waveform. The feature extractor 304 outputs parameters associated with the extracted features to the transmission data generator 305. The feature extractor 304 correlates the parameters associated with the features with a sensor ID in outputting the parameters associated with the features. The sensor ID indicates identification information for identifying the first sensor 20 which is installed in an area in which soundness of the structure 50 is to be evaluated (hereinafter referred to as an "evaluation area").

The amplitude of a waveform is, for example, a value of a maximum amplitude in the noise-removed signal. The ascending time of a waveform is, for example, a time T1 from an ascending start of the gate signal until the noise-removed signal reaches a maximum value. The sustainment time of the gate signal is, for example, a time from an ascending start of the gate signal until the amplitude becomes less than a preset value. The zero-cross count is, for example, the number of times the noise-removed signal crosses a reference line passing through a zero value.

The energy of a waveform is, for example, a value obtained by integrating a square of the amplitude of the noise-removed signal at each time point with respect to time. Definition of the energy is not limited to the aforementioned example, and may be, for example, approximation using an envelope of a waveform. The frequency is a frequency of the noise-removed signal. The RMS value is, for example, a value obtained by squaring the amplitude of the noise-removed signal at each time point and taking a square root thereof.

The transmission data generator 305 receives the sensor ID, the time information, and the parameters associated with the features as inputs. The transmission data generator 305 generates transmission data including the input sensor ID, the input time information, and the input parameters associated with the features.

The memory 306 stores one or more pieces of transmission data generated by the transmission data generator 305. The memory 306 is, for example, a dual port random access memory (RAM).

The output 307 sequentially outputs the one or more pieces of transmission data stored in the memory 306 to the structure evaluation apparatus 40. For example, when the signal processor 30 and the structure evaluation apparatus 40 are connected to each other in a wired manner, the output 307 outputs one or more pieces of transmission data stored in the memory 306 to the structure evaluation apparatus 40 via a wired cable. When the signal processor 30 and the structure evaluation apparatus 40 are connected to each other in a wireless manner, the output 307 wirelessly outputs one or more pieces of transmission data stored in the memory 306 to the structure evaluation apparatus 40.

Description will be continued with reference back to FIG. 1. The structure evaluation apparatus 40 includes a communicator 41, a controller 42, a storage 43, and a display 44.

The communicator 41 receives the one or more pieces of transmission data output from the signal processor 30. In addition, the communicator 41 receives the estimation result output from the vehicle information estimator 35.

The controller 42 controls the structure evaluation apparatus 40 as a whole. The controller 42 is constituted by a processor such as a central processing unit (CPU) and a memory. The controller 42 serves as an acquirer 421, an event extractor 422, a position locator 423, a distribution generator 424, a corrector 425, and an evaluator 426 by executing a program.

Some or all of the functional units such as the acquirer 421, the event extractor 422, the position locator 423, the distribution generator 424, the corrector 425, and the evaluator 426 may be realized by hardware such as an application-specific integrated circuit (ASIC), a programmable logic device (PLD), or an FPGA or may be cooperatively realized by software and hardware. The program may be stored in a computer-readable recording medium. The computer-readable recording medium is, for example, a non-transitory storage medium such as a portable medium such as a flexible disk, a magneto-optical disc, a read only memory (ROM), or a CD-ROM or a storage device such as a hard disk incorporated into a computer system. The program may be transmitted via a telecommunication line.

Some functional units such as the acquirer 421, the event extractor 422, the position locator 423, the distribution generator 424, the corrector 425, and the evaluator 426 do not have to be mounted in the structure evaluation apparatus 40 in advance and may be realized by installing an additional application program in the structure evaluation apparatus 40.

The acquirer 421 acquires various types of information. For example, the acquirer 421 acquires the transmission data and the estimation result received by the communicator 41. The acquirer 421 acquires the transmission data to correspond to an evaluation period. The acquirer 421 stores the acquired transmission data and the acquired estimation result in the storage 43.

The event extractor 422 extracts transmission data in one event out of the transmission data in the evaluation period stored in the storage 43. The event means an elastic wave generation event having occurred in the structure 50. The elastic wave generation event in this embodiment is passage of a vehicle 10 on a road surface. When one event has occurred, elastic waves 11 are detected substantially at the same time by the plurality of first sensors 20. That is, transmission data associated with the elastic waves 11 detected substantially at the same time is stored in the storage 43. Therefore, the event extractor 422 provides a predetermined time window and extracts all pieces of transmission data in which an arrival time is within the range of the time window as transmission data in one event. The event extractor 422 outputs the extracted transmission data in one event to the position locator 423.

The range Tw of the time window may be determined using an elastic wave propagation speed v in the structure 50 to be evaluated and a maximum sensor interval dmax such that $Tw \geq dmax/v$ is satisfied. Since Tw is preferably set to be as small as possible in order to avoid erroneous detection, $Tw=dmax/v$ can be substantially set. The elastic wave propagation speed v may be calculated in advance.

The position locator 423 locates positions of elastic wave sources on the basis of sensor position information and sensor IDs and time information included in a plurality of pieces of transmission data extracted by the event extractor 422.

The sensor position information includes information on installation positions of the first sensors 20 in correlation with the sensor IDs. The sensor position information includes, for example, information on installation positions of the first sensors 20 such as latitude and longitude or distances in the horizontal direction and the vertical direction from a reference position of the structure 50. The position locator 423 stores the sensor position information in advance. The sensor position information may be stored in the position locator 423 at any timing before position location of elastic wave sources is performed by the position locator 423.

The sensor position information may be stored in the storage 43. In this case, the position locator 423 acquires the sensor position information from the storage 43 at a timing at which the position location is performed. A Kalman filter, a least square method, or the like may be used to locate positions of elastic wave sources. The position locator 423 outputs position information of elastic wave sources acquired in the evaluation period to the distribution generator 424.

The distribution generator 424 receives the position information of a plurality of elastic wave sources output from the position locator 423 as an input. The distribution generator 424 generates an elastic wave source distribution using the input position information of the plurality of elastic wave sources. The elastic wave source distribution indicates a distribution in which positions of the elastic wave sources are marked. More specifically, the elastic wave source distribution is a distribution in which points indicating positions of elastic wave sources are marked on virtual data representing the structure 50 to be evaluated with the horizontal axis set to a distance in a passing direction and with the vertical axis set to a distance in the lateral direction.

The distribution generator 424 generates an elastic wave source density distribution using the elastic wave source distribution. The elastic wave source density distribution represents a distribution in which a value of a density calculated according to the number of elastic wave sources included in each area is expressed for each predetermined area in the elastic wave source distribution. Specifically, first, the distribution generator 424 divides the elastic wave source distribution into a plurality of areas by partitioning the elastic wave source distribution into predetermined sections. Then, the distribution generator 424 calculates a density D of each area on the basis of Expression (1). The distribution generator 424 calculates an elastic wave source density distribution for each area by allocating the value of the calculated density D for each area to the corresponding area. In this way, the distribution generator 424 generates the elastic wave source density distribution by calculating the densities D corresponding to an evaluation area. In Expression (1), $N_{ev}$ denotes the number of elastic wave sources located in an area, and S denotes an area of the corresponding area.

$$D = \frac{N_{ev}}{S} \qquad \cdots (1)$$

The corrector 425 corrects the elastic wave source density distribution generated by the distribution generator 424 on the basis of the estimation result stored in the storage 43. Specifically, the corrector 425 corrects the elastic wave source density distribution on the basis of the number of vehicles indicated by the estimation result. More specifically, the corrector 425 calculates the density D of each area on the basis of Expression (2). Thereafter, the corrector 425 calculates a density in a predetermined area by dividing the number of elastic wave sources of which the positions are located in the predetermined area by the area of the predetermined area. The corrector 425 corrects the elastic wave source density distribution by allocating the calculated densities D of the areas to the corresponding areas of the elastic wave source density distribution. Allocation to the corresponding areas of the elastic wave source density distribution means overwriting with the calculated densities D of the areas. In this way, the corrector 425 corrects the elastic wave source density distribution by newly calculating the densities D of the areas in the evaluation area. In Expression (2), $N_{car}$ denotes the number of vehicles indicated by the estimation result.

$$D = \frac{N_{ev}}{n_{car} \cdot S} \qquad \cdots (2)$$

The evaluator 426 evaluates a deterioration state of the structure 50 using the elastic wave source density distribution corrected by the corrector 425. For example, the evaluator 426 evaluates an area in which the elastic wave source density is equal to or greater than a threshold value in the corrected elastic wave source density distribution as a sound area and evaluates an area in which the elastic wave source density is less than the threshold value as a damaged area.

The transmission data corresponding to the evaluation period and the estimation result acquired by the acquirer 421 are stored in the storage 43. The storage 43 is constituted by a storage device such as a magnetic hard disk device or a semiconductor storage device.

The display 44 displays an evaluation result under the control of the evaluator 426. The display 44 may display the corrected elastic wave source density distribution as an evaluation result or may display an area which is considered as a damaged area using a different display mode from that of other areas. The display 44 displays a dotted line group indicating propagation paths of elastic waves from each elastic wave source to the first sensors 20, for example, using a projection method under the control of the evaluator 426. The display 44 is an image display device such as a liquid crystal display or an organic electroluminescence (EL) display. The display 44 may be an interface for connecting the image display device to the structure evaluation apparatus 40. In this case, the display 44 generates an image signal for displaying the evaluation result and outputs the image signal to the image display device connected thereto.

(Arrangement of sensors)

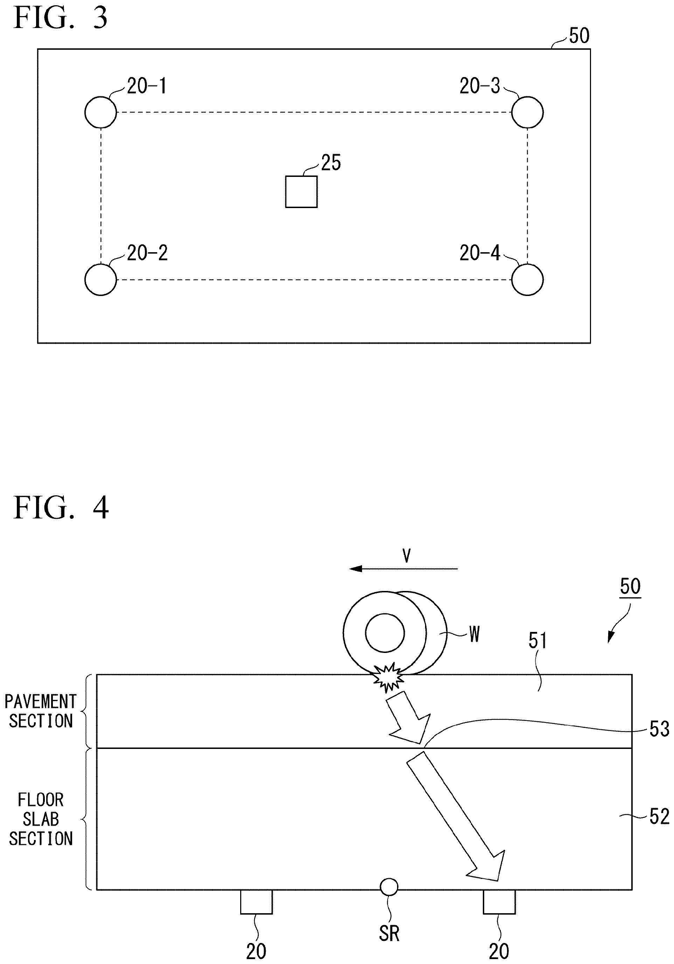

FIG. 3 is a diagram illustrating arrangement of sensors in the first embodiment. FIG. 3 illustrates an example in which the first sensors 20 and the second sensor 25 are arranged on the bottom surface of the structure 50. For example, in FIG. 3, four first sensors 20-1 to 20-4 and one second sensor 25 are arranged on the bottom surface of the structure 50. In the example illustrated in FIG. 3, an area surrounded by the four first sensors 20-1 to 20-4 (an area surrounded by a dotted line in FIG. 3) is an evaluation area. At least one second sensor 25 can be installed in the area surrounded by a plurality of first sensors 20.

(Acoustic wave measuring method)

FIG. 4 is a diagram illustrating an elastic wave measuring method according to the first embodiment. In FIG. 4, it is conceivable that internal damage in the structure 50 be evaluated on the basis of elastic waves generated by a traveling unit W (for example, a tire) of each vehicle 10 traveling on the road surface as an example of the elastic wave measuring method. Here, it is assumed that the structure 50 is a road on which vehicles 10 travel. The vehicles 10 are not particularly limited and may be regular traveling vehicles. Since elastic waves generated by regular vehicles 10 are used, vehicle limitation does not need to be performed for inspection, which contributes to improvement of a user's convenience. A load is applied to the road surface due to a contact between the traveling unit W of a vehicle 10 and the road surface. Accordingly, elastic waves are generated in the structure 50. The generated elastic waves propagate in the structure 50 and are detected by the first sensors 20 installed on a surface (for example, a bottom surface) other than the road surface.

In general, a structure 50 includes a pavement section 51 on which vehicles can travel and a floor slab section 52 that supports the pavement section 51. The pavement section 51 is formed of, for example, asphalt and the floor slab section 52 is formed of, for example, concrete. The thickness of a general pavement section 51 is about 80 mm, and the thickness of the floor slab section 52 is about 180 mm to 230 mm. elastic waves (with amplitude $A_{src}$) generated due to an interaction between the traveling unit W of a vehicle 10 traveling on the road surface at a speed V and the surface of the pavement section 51 propagate to the bottom surface of the floor slab section 52. On the way, the elastic waves are partially reflected and partially transmitted by an interface 53 between the pavement section 51 and the floor slab section 52 due to a difference in acoustic impedance there between. The elastic waves propagating to the bottom surface of the floor slab section 52 arrive at the first sensors 20 and are detected by the first sensors 20. A plurality of first sensors 20 are installed on the bottom surface of the floor slab section 52, and the elastic waves are detected by the first sensors 20 with time differences. A position of an elastic wave sources SR is located on the basis of the time differences when the elastic waves have been detected by the plurality of first sensors 20.

(Method of detecting passage of vehicle 10)

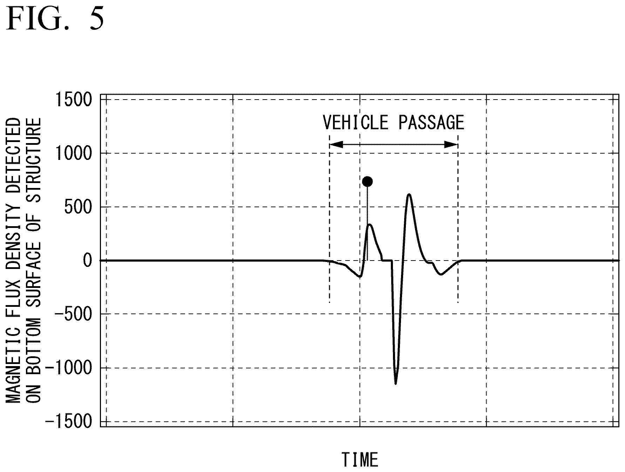

FIG. 5 is a diagram illustrating a method of detecting passing of a vehicle 10 which is performed by the second sensor 25 according to the first embodiment. FIG. 5 illustrates a measurement result of a magnetic flux density when the second sensor 25 is installed on the bottom surface of the structure 50 and a vehicle 10 (for example, a large vehicle of a 10 m class) passes on the top surface of the structure 50. Referring to FIG. 5, it can be seen that maximum change in a magnetic flux density of 500 nT occurs when a large vehicle of a 10 m class passes. In this way, when a vehicle 10 passes on the top surface of the structure 50 in which the second sensor 25 is installed, change in a magnetic flux density is detected. Accordingly, it is possible to detect passage of a vehicle 10 by detecting change in a magnetic flux density using the second sensor 25. In FIG. 5, the measurement result of a magnetic flux density when one vehicle 10 passes on the top surface of the structure 50 is illustrated, but it is considered that a plurality of vehicles 10 pass continuously on the top surface of the structure 50. In this case, waveforms which are temporally continuous are detected by the second sensor 25 and change of a magnetic flux density based on the passing vehicles 10 is measured.

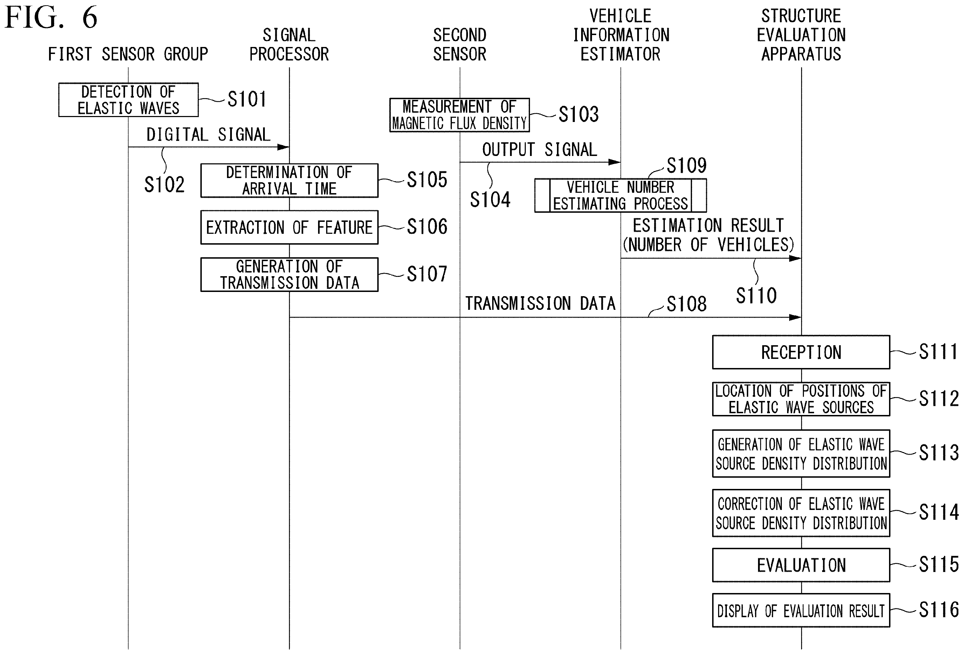

FIG. 6 is a sequence diagram illustrating a routine of a deterioration state evaluating process which is performed by the structure evaluation system 100 according to the first embodiment. The routine illustrated in FIG. 6 is performed when a vehicle 10 travels on the structure 50 to be evaluated. In FIG. 6, a plurality of first sensors 20 are described as a first sensor group.

When a vehicle 10 passes on the structure 50 to be evaluated, the traveling unit of the vehicle 10 comes into contact with the road surface. Accordingly, elastic waves 11 are generated in the structure 50. Each of the plurality of first sensors 20 detects the elastic waves 11 generated in the structure 50 (Step S101). Each of the plurality of first sensors 20 converts the detected elastic waves 11 to an electrical signal and outputs the electrical signal to the signal processor 30 (Step S102). The electrical signal output from each of the plurality of first sensors 20 is amplified by an amplifier which is not illustrated. Noise components of the amplified electrical signal are removed by the filter and the resultant electrical signal is converted to a digital signal by the analog-digital converter.

The second sensor 25 measures a magnetic flux density which is generated due to passage of the vehicle 10 on the structure 50 (Step S103). The second sensor 25 outputs an output signal which is time-series data of change in the measured magnetic flux density to the vehicle information estimator 35 (Step S104). The output signal output from the second sensor 25 is amplified by an amplifier which is not illustrated. Noise components of the amplified measurement result are removed by a filter and then the resultant measurement result is converted to a digital signal by the analog-digital converter and is input to the vehicle information estimator 35.

The signal processor 30 receives the digital signal output from the analog-digital converter as an input. The arrival time determiner 303 of the signal processor 30 determines an arrival time of each elastic wave 11 (Step S105). Specifically, the arrival time determiner 303 determines an elastic wave arrival time using a clock input while the first gate signal is being input. The arrival time determiner 303 outputs the determined elastic wave arrival time as time information to the transmission data generator 305. The arrival time determiner 303 performs this process on all the input digital signals.

The feature extractor 304 of the signal processor 30 extracts a feature of a noise-removed signal using the noise-removed signal which is a digital signal input while the first gate signal is being input (Step S106). The feature extractor 304 outputs parameters associated with the extracted feature to the transmission data generator 305. The transmission data generator 305 generates transmission data including the sensor IDs, the time information, and the parameters associated with the feature (Step S107). The transmission data generator 305 stores the generated transmission data in the memory 306. The output 307 sequentially outputs the transmission data stored in the memory 306 to the structure evaluation apparatus 40 (Step S108).

The vehicle information estimator 35 acquires the output signal output from the second sensor 25 in an evaluation period. The vehicle information estimator 35 performs a vehicle number estimating process using the acquired output signal corresponding to the evaluation period (Step S109). The vehicle number estimating process is a process of estimating the number of vehicles 10 passing through the evaluation area in the evaluation period. The vehicle number estimating process will be described later. The vehicle information estimator 35 estimates passing vehicle number information as a result of the vehicle number estimating process. The vehicle information estimator 35 generates an estimation result indicating the estimated passing vehicle number information. The vehicle information estimator 35 outputs the generated estimation result to the structure evaluation apparatus 40 (Step S 110).

The communicator 41 of the structure evaluation apparatus 40 receives the transmission data output from the signal processor 30 and the estimation result output from the vehicle information estimator 35 (Step S111). The signal processor 30 and the vehicle information estimator 35 are different devices. Accordingly, basically, the communicator 41 receives the transmission data output from the signal processor 30 and the estimation result output from the vehicle information estimator 35 at different timings. The acquirer 421 acquires the transmission data and the estimation result received by the communicator 41. The acquirer 421 records the acquired transmission data and the acquired estimation result in the storage 43. The acquirer 421 records all the transmission data received in the evaluation period in the storage 43.

The event extractor 422 extracts transmission data in one event out of the transmission data corresponding to the evaluation period stored in the storage 43 after the evaluation period has elapsed or in response to an instruction from the outside. The event extractor 422 outputs the extracted transmission data in one event to the position locator 423. At this time, the event extractor 422 performs a process of extracting transmission data in one event and a process of outputting the extracted transmission data in one event in a time series.

The position locator 423 locates positions of elastic wave sources on the basis of the sensor IDs and the time information included in the transmission data output from the event extractor 422 and the sensor position information stored in advance (Step S112). Specifically, first, the position locator 423 calculates a difference in arrival time of the elastic waves 11 between the plurality of first sensors 20. Then, the position locator 423 locates the positions of the elastic wave sources using the sensor position information and information of the difference in arrival time.

The position locator 423 performs the process of Step S 112 when transmission data in one event is output from the event extractor 422 in the evaluation period. Accordingly, the position locator 423 locates the positions of the plurality of elastic wave sources which are generated in the evaluation period. The position locator 423 outputs the position information of the plurality of elastic wave sources to the distribution generator 424.

The distribution generator 424 generates an elastic wave source distribution using the position information of the plurality of elastic wave sources output from the position locator 423. Specifically, the distribution generator 424 generates the elastic wave source distribution by plotting the positions of the elastic wave sources indicated by the acquired position information of the plurality of elastic wave sources onto virtual data. The distribution generator 424 generates an elastic wave source density distribution using the generated elastic wave source distribution (Step S113). The distribution generator 424 outputs the generated elastic wave source density distribution to the corrector 425.

The corrector 425 receives the elastic wave source density distribution output from the distribution generator 424 and the estimation result stored in the storage 43 as inputs. The corrector 425 corrects the elastic wave source density distribution on the basis of the input elastic wave source density distribution and the input estimation result (Step S114). Specifically, the corrector 425 corrects the elastic wave source density distribution on the basis of Expression (2). The corrector 425 outputs the corrected elastic wave source density distribution to the evaluator 426.

The evaluator 426 evaluates a deterioration state of the structure using the corrected elastic wave source density distribution (Step S115). The evaluator 426 outputs an evaluation result to the display 44. The display 44 displays the evaluation result output from the evaluator 426 (Step S116).

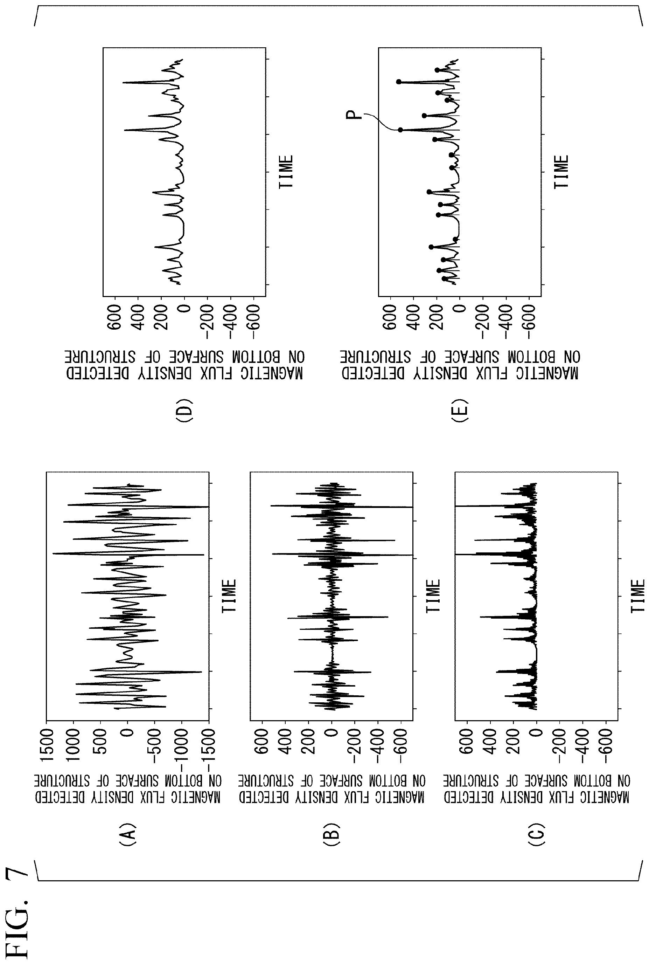

FIG. 7 is a diagram illustrating a vehicle number estimating process which is performed by the vehicle information estimator 35 according to the first embodiment. A waveform illustrated in (A) of FIG. 7 is an output signal output from the second sensor 25 in an evaluation period. That is, the waveform illustrated in (A) of FIG. 7 indicates waveform data input to the vehicle information estimator 35. The vehicle information estimator 35 samples the input output signal and removes noise therefrom using a filter circuit according to necessity. Specifically, first, the vehicle information estimator 35 applies a digital filter (for example, with a cut-off frequency of 3 Hz) to the output signal to separate vehicles 10 which are traveling continuously. Accordingly, the output signal illustrated in (A) of FIG. 7 becomes a signal illustrated in (B) of FIG. 7. Then, the vehicle information estimator 35 converts a signal to which the digital filter is applied to a signal of a positive polarity using an absolute value circuit. That is, the vehicle information estimator 35 converts the signal to which the digital filter is applied to a signal of a positive polarity by taking the absolute value of the signal to which the digital filter is applied. Accordingly, the signal illustrated in (B) of FIG. 7 becomes a signal illustrated in (C) of FIG. 7.

Therefore, the vehicle information estimator 35 extracts an envelope by causing the signal of the positive polarity to pass through a low-pass filter (for example, with a cut-off frequency of 3 Hz). Extraction of an envelope may be performed using an analog circuit or may be performed using an effective value circuit, a Hilbert transformation circuit, or the like. Through this process, the signal illustrated in (C) of FIG. 7 becomes a signal illustrated in (D) of FIG. 7. Finally, the vehicle information estimator 35 detects peaks in the extracted envelope. For example, the vehicle information estimator 35 provides a predetermined time window Tw1 (Tw1=0.5 seconds herein) and extracts a peak value P in the predetermined time window Tw1. The vehicle information estimator 35 performs the peak detecting process while shifting the predetermined time window Tw1 in the time direction. Accordingly, a plurality of peak values P are extracted as illustrated in (E) of FIG. 7. For example, in the example illustrated in (E) of FIG. 7, 17 peak values P are extracted. The vehicle information estimator 35 estimates the number of extracted peak values P as the number of vehicles passing through the evaluation area in the evaluation period.

By performing the aforementioned processes, the vehicle information estimator 35 estimates the number of extracted peak values P as the number of vehicles passing through the evaluation area in the evaluation period. The vehicle information estimator 35 includes at least a digital filter, an absolute value circuit, a low-pass filter, a peak detector, and a vehicle number estimator as functions for estimating the number of vehicles. The absolute value circuit converts a signal to a signal of a positive polarity. The peak detector detects a peak (a peak value P) in an envelope. The vehicle number estimator estimates the number of peak values P (a number obtained by integrating the peaks) detected by the peak detector as the number of vehicles passing through the evaluation area in the evaluation period.

The structure evaluation system 100 having the aforementioned configuration includes a plurality of first sensors 20 that detect elastic waves, a second sensor 25 that detects passage of a vehicle 10 without depending on damage in a structure 50, a vehicle information estimator 35 configured to estimate vehicle information including at least passing vehicle number information on the basis of a sensing result from the second sensor 25, and an evaluator 426 configured to evaluate a deterioration state of the structure 50 on the basis of a plurality of elastic waves detected by the plurality of first sensors 20 and the vehicle information estimated by the vehicle information estimator 35.

In this way, the structure evaluation system 100 includes the second sensor 25 that detects passage of a vehicle 10 without depending on damage in the structure 50 in addition to the plurality of first sensors 20 that detect elastic waves. Accordingly, it is possible to detect passage of a vehicle 10 even when damage in the structure 50 is intensive. The vehicle information estimator 35 estimates at least the number of vehicles 10 passing on the structure 50 on the basis of the sensing result from the second sensor 25. As described above, the second sensor 25 detects passage of a vehicle 10 by detecting change in a magnetic flux density generated due to passage of the vehicle 10 using a magnetic sensor without depending on damage in the structure 50. Accordingly, the vehicle information estimator 35 can accurately measure the number of vehicles. As a result, it is possible to solve the problem that measurement accuracy of the number of vehicles decreases when damage in the structure is intensive. In this way, a factor which has decreased accuracy of an evaluation result in the related art is not generated in the structure evaluation system 100. Accordingly, it is possible to accurately estimate the number of vehicles without depending on damage in the structure and to evaluate a deterioration state of the structure.

The corrector 425 of the structure evaluation apparatus 40 corrects the elastic wave source density distribution on the basis of the passing vehicle number information estimated by the vehicle information estimator 35. Accordingly, the elastic wave source density distribution acquired on the basis of a plurality of elastic waves detected by the first sensors 20 affected by damage in the structure 50 is corrected in consideration of the passing vehicle number information estimated on the basis of the output signal of the second sensor 25 not affected by damage in the structure 50. Accordingly, it is possible to improve evaluation accuracy of a structure.

(Modified example of first embodiment)

The distribution generator 424 of the structure evaluation apparatus 40 may be configured to generate an elastic wave source density distribution in consideration of the passing vehicle number information estimated by the vehicle information estimator 35 in a step of generating the elastic wave source density distribution. With this configuration, the structure evaluation apparatus 40 may not include the corrector 425. Specifically, first, the distribution generator 424 divides an elastic wave source distribution into a plurality of areas by partitioning the elastic wave source distribution into predetermined sections. Then, the distribution generator 424 calculates a density D of each area on the basis of Expression (2). Then, the distribution generator 424 generates an elastic wave source density distribution by allocating the calculated value of the density D of the areas to the areas. In this way, the distribution generator 424 generates the elastic wave source density distribution by calculating the densities D in the evaluation area in consideration of the passing vehicle number information estimated by the vehicle information estimator 35. The evaluator 426 evaluates the deterioration state of the structure 50 using the generated elastic wave source density distribution. With this configuration, the elastic wave source density distribution generated by the distribution generator 424 does not need to be corrected. Accordingly, it is possible to reduce the number of processes in the structure evaluation apparatus 40.

(Second embodiment)

A second embodiment employs a configuration in which a vehicle information estimator estimates a vehicle type in addition to the number of vehicles on the basis of an output signal of the second sensor, a signal processor performs filtering based on the vehicle type, and a structure evaluation apparatus performs processing using only information of a specific vehicle type.

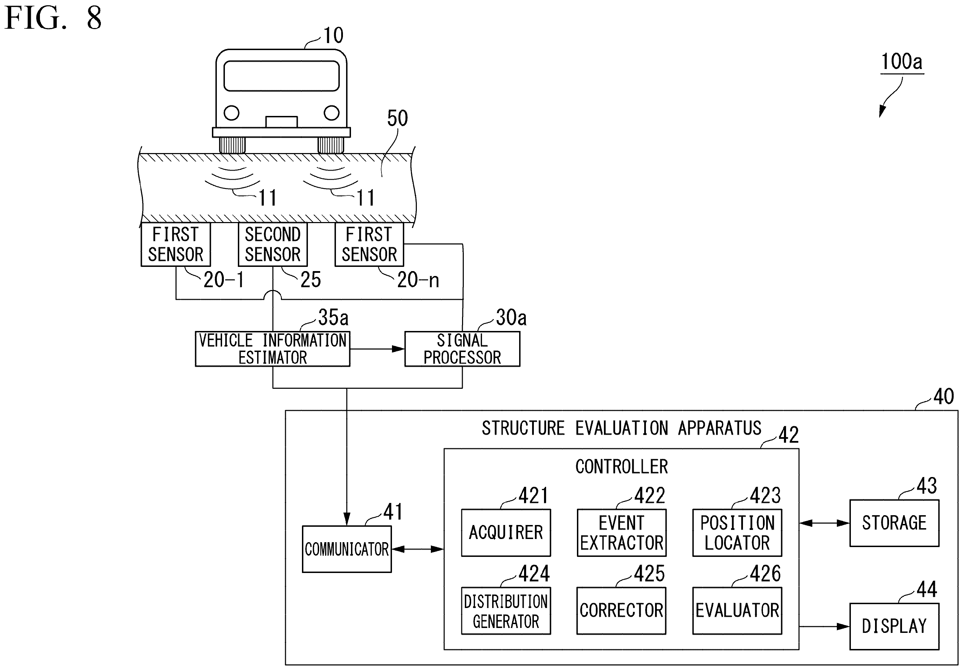

FIG. 8 is a diagram illustrating a configuration of a structure evaluation system 100a according to the second embodiment. The structure evaluation system 100a is used to evaluate soundness of a structure 50. The structure evaluation system 100a includes a plurality of first sensors 20-1 to 20-n, a second sensor 25, a signal processor 30a, a vehicle information estimator 35a, and a structure evaluation apparatus 40. The plurality of first sensors 20-1 to 20-n and the signal processor 30a are communicatively connected to each other in a wired manner. The second sensor 25 and the vehicle information estimator 35a are communicatively connected to each other in a wired manner. The signal processor 30a and the vehicle information estimator 35a are communicatively connected to each other in a wired manner. The signal processor 30a and the structure evaluation apparatus 40 are communicatively connected to each other in a wired or wireless manner, and the vehicle information estimator 35a and the structure evaluation apparatus 40 are communicatively connected to each other in a wired or wireless manner.

The structure evaluation system 100a has a configuration different from the structure evaluation system 100 in that the signal processor 30a and the vehicle information estimator 35a are provided instead of the signal processor 30 and the vehicle information estimator 35. The structure evaluation system 100a has the same configuration as the structure evaluation system 100 in the other configuration. Differences from the structure evaluation system 100 will be mainly described below.

The vehicle information estimator 35a receives an output signal output from the second sensor 25 as an input. The vehicle information estimator 35a estimates vehicle information on the basis of the input output signal. Specifically, the vehicle information estimator 35a estimates the number of vehicles 10 and vehicle types of the vehicles 10. Estimation of a vehicle type of a vehicle 10 is performed by the vehicle information estimator 35a when passage of one vehicle 10 is detected. The vehicle information estimator 35a outputs an estimation result indicating the estimated passing vehicle number information to the structure evaluation apparatus 40. The vehicle information estimator 35a outputs an estimation result indicating information of the estimated vehicle type of the vehicle 10 to the signal processor 30a. The vehicle information estimator 35a includes a timepiece. The timepiece acquires time information.

The time of the timepiece of the vehicle information estimator 35a is the same as the time in the signal processor 30a. That is, the timepiece of the vehicle information estimator 35a and the signal processor 30a acquire time information indicating the same time. In this way, before measurement, the time of the timepiece of the vehicle information estimator 35a and the time in the signal processor 30a may be adjusted to be the same by a user. When the time is set with high accuracy, time synchronization may be taken between the vehicle information estimator 35a and the signal processor 30a. The vehicle information estimator 35a transmits the estimation result including the time information along with the information of the estimated vehicle type of the vehicle 10 to the signal processor 30a. Specifically, when it is assumed that a time at which one large vehicle passes is between time T and time $T+\Delta t$, the vehicle information estimator 35a transmits the estimation result including the information of the vehicle type of the vehicle 10 and the information of the time T and the passing time Δt to the signal processor 30a. In this way, in the second embodiment, the vehicle information includes the passing vehicle number information and the vehicle type information.

The signal processor 30a receives a digital signal output from an analog-digital converter and an estimation result output from the vehicle information estimator 35a as inputs. The signal processor 30a performs signal processing on the input digital signal. The signal processor 30a generates transmission data including the digital signal subjected to the signal processing. The signal processor 30a performs filtering based on a vehicle type on the basis of the estimation result. Here, the filtering based on a vehicle type means that transmission data other than a specific vehicle type is not output. For example, the signal processor 30a outputs only transmission data corresponding to a designated vehicle type out of the generated transmission data to the structure evaluation apparatus 40. In this way, when information of the vehicle type indicated by the estimation result corresponding to the generated transmission data is other than a designated vehicle type, the signal processor 30a does not output the generated transmission data to the structure evaluation apparatus 40. On the other hand, when information of the vehicle type indicated by the estimation result corresponding to the generated transmission data is a designated vehicle type, the signal processor 30a outputs the generated transmission data to the structure evaluation apparatus 40. A vehicle type corresponding to the transmission data to be output may be set in advance by a user or may be instructed from an external device.

The information of a vehicle type is, for example, information for identifying a vehicle type of a vehicle 10 passing on the structure 50 such as a large vehicle and a regular vehicle. In the following description, two types of a large vehicle and a regular vehicle will be described as the information of a vehicle type for the purpose of simplification of explanation, but the number of vehicle types may be three or more. Here, a large vehicle is defined as a vehicle with a vehicle length equal to or greater than 5 m, and a regular vehicle is defined as a vehicle with a vehicle length less than 5 m. When filtering is performed as described above, the information of a vehicle type needs to be correlated with the digital signal input to the signal processor 30a. When the information of a vehicle type is correlated with the digital signal, for example, the signal processor 30a may correlate the information of a vehicle type with transmission data generated on the basis of the digital signal. This is because the digital signal input to the signal processor 30a and the transmission data generated on the basis of the digital signal are substantially the same. When the information of a vehicle type is correlated with the transmission data, the signal processor 30a performs correlation of the transmission data with the information of a vehicle type on the basis of the time information included in the transmission data and the time information included in the estimation result. Specifically, when the elastic wave arrival time indicated by the time information included in the transmission data is a time in a range (a range from time T to time T+Δt) indicated by the time information included in the estimation result, the signal processor 30a can correlate the information of a vehicle type included in the estimation result with the transmission data. Accordingly, it is possible to the information of a vehicle type of a vehicle 10 with all the pieces of transmission data associated with elastic waves generated in the range (the range from time T to time T+Δt) indicated by the time information.

The signal processor 30a determines whether the generated transmission data is transmission data of a large vehicle or transmission data of a regular vehicle on the basis of the information of a vehicle type correlated with the transmission data and outputs only transmission data corresponding to the designated vehicle type to the structure evaluation apparatus 40. The transmission data output from the signal processor 30a means outputting of a feature of elastic waves. Similarly, a plurality of pieces of transmission data output from the signal processor 30a means outputting of features of a plurality of elastic waves.

The aforementioned method is an example, and correlation of the information of a vehicle type of a vehicle 10 with the transmission data may be performed using another method. For example, it is assumed that the vehicle information estimator 35a transmits an estimation result including the information of a vehicle type of a vehicle 10 and information of time T to the signal processor 30a. In this way, when information of only time T at which passage of a large vehicle has been detected (not including information of the passing time Δt) is acquired by the signal processor 30a, first, the signal processor 30a acquires time T included in the estimation result. Then, the signal processor 30a determines whether the elastic wave arrival time indicated by the time information included in the transmission data is included in the range from time T to time T+Δt obtained by adding a predetermined fixed time Δt to the acquired time T. When the elastic wave arrival time indicated by the time information included in the transmission data is included in the range from time T to time T+Δt, the signal processor 30a correlates the information of a vehicle type of a vehicle 10 included in the estimation result with the transmission data. On the other hand, when the elastic wave arrival time indicated by the time information included in the transmission data is not included in the range from time T to time T+Δt, the signal processor 30a does not correlate the information of a vehicle type of a vehicle 10 included in the estimation result with the transmission data. Basically, when a vehicle 10 passes on the structure 50, elastic waves are detected and the vehicle 10 is detected. Accordingly, the correlation is considered to be normally possible. With this method, it is possible to reduce a processing load in the vehicle information estimator 35a. In the following description, it is assumed that information of time T and a passing time Δt is included as time information in the estimation result.

A configuration in which the signal processor 30a correlates information of a vehicle type with transmission data when filtering is performed has been described above, but the timing of correlation of the information of a vehicle type is not limited to a timing after transmission data has been generated. For example, the signal processor 30a may correlate the information of a vehicle type with a digital signal before the transmission data has been generated. In this case, the signal processor 30a may correlate the information of a vehicle type with a digital signal at any timing after the elastic wave arrival time extracted on the basis of the digital signal has been acquired and before the transmission data has been generated. In this way, the signal processor 30a can correlate the information of a vehicle type of a vehicle 10 with the input digital signal at various timings. The signal processor 30a may not generate transmission data when the vehicle type is not a designated vehicle type. Accordingly, it is not necessary to generate transmission data which is not to be transmitted. As a result, it is possible to reduce a load of the signal processor 30a.

The signal processor 30a is constituted by an analog circuit or a digital circuit. The digital circuit is realized by, for example, an FPGA or a microcomputer. The digital circuit may be realized by a dedicated LSI. A nonvolatile memory such as a flash memory or a removable memory may be mounted in the signal processor 30a.

(Vehicle type estimating method)

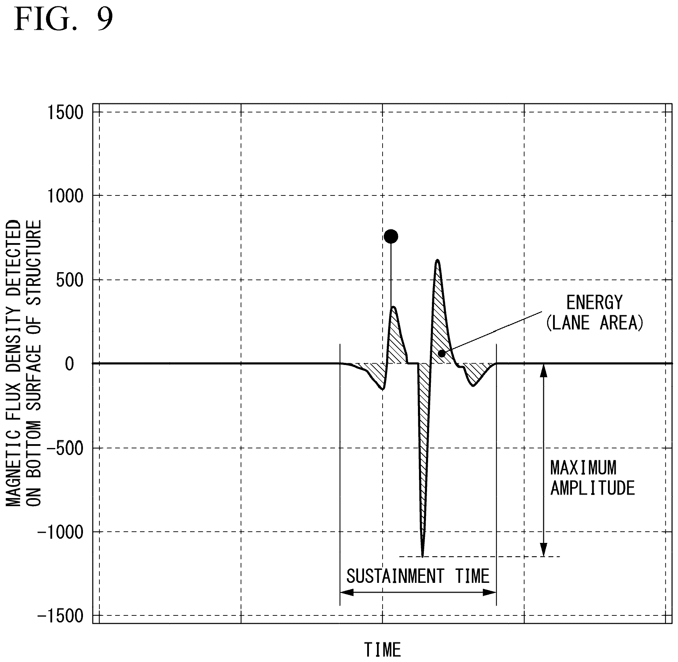

A vehicle type estimating process which is performed by the vehicle information estimator 35a will be described below. The vehicle information estimator 35a extracts a feature using an output signal of the second sensor 25 to discriminate a vehicle type of a vehicle 10. For example, the vehicle information estimator 35a extracts one of maximum amplitude, energy (area), and a sustainment time of the output signal illustrated in FIG. 9 as a feature. FIG. 9 is a diagram illustrating an example of a feature extracted using the output signal of the second sensor 25. The vehicle information estimator 35a may extract a gravity center frequency or a peak frequency obtained by Fourier-transforming the output signal as a feature or may extract a parameter in which the maximum amplitude, the energy (area), the sustainment time, the gravity center frequency and the peak frequency of the output signal are combined as a feature.

The vehicle information estimator 35a estimates a vehicle type of a vehicle 10 using a trained model which has been trained to output information of a vehicle type with one or more features as an input. The trained model is a machine learning model in which learning ending conditions of a machine learning model have been satisfied. The learning ending conditions is not particularly limited as long as they are conditions associated with ending of learning and may be, for example, a condition that a training target has been updated a predetermined number of times or a condition that change of a training target due to update is less than predetermined change. When the learning ending conditions of a machine learning model are satisfied, parameters (weights) used for the trained model are optimized. A logistic regression model, a neural network, a support vector machine (SVM), a decision tree, or the like may be used as the machine learning model.

In the following description, it is assumed that a logistic regression model is used as a machine learning model. When $x_1$ and $x_2$ are explanatory variables, a logistic regression model outputting a vehicle type class $V_{type}$ (0: regular vehicle, 1: large vehicle) is expressed as Expression (3). In Expression (3), $a_0$, $a_1$, and $a_2$ denote weights. One or more features extracted by the vehicle information estimator 35a are input as the explanatory variables $x_1$ and $x_2$. In selecting the explanatory variables $x_1$ and $x_2$, it is effective to exclude a combination with a high correlation between variables in order to avoid multicollinearity.

$$v_{type} = \frac{1}{1 + e^{-(a_0 + a_1 x_1 + a_2 x_2)}} \quad \cdots \text{（３）}$$

Learning for obtaining a trained model will be described below. A training target in learning for obtaining a trained model is a mathematical model estimating a vehicle type on the basis of one or more features. More specifically, a training target in learning for obtaining a trained model is a mathematical model classifying vehicle types into a plurality of classes on the basis of one or more features. In the following description, a mathematical model estimating a vehicle type on the basis of one or more features is referred to as a vehicle-type-estimation trained model. Learning of a vehicle-type-estimation trained model is, for example, supervised learning. In this case, learning data used for learning for obtaining a vehicle-type-estimation trained model includes answer data. The learning data used for learning of a vehicle-type-estimation trained model is a set of one or more features and values indicating vehicle type classes (for example, a large vehicle and a regular vehicle). In order to avoid multicollinearity, for example, two features including an energy/amplitude ratio and a gravity center frequency are used as the one or more features used for learning data. The energy/amplitude ratio is a value obtained by dividing energy by the amplitude ratio. A combination of one or more features used for learning data is not limited thereto.

Values indicating vehicle type classes are used as answer data in learning. Accordingly, one or more features are input to a machine learning model in learning. In learning of a machine learning model, the machine learning model estimates a value indicating a vehicle type class on the basis of one or more features included in the learning data. Thereafter, training of the machine learning model is performed by updating the machine learning model until the learning ending conditions are satisfied such that a difference between the value indicating the vehicle type class estimated by the machine learning model and the value indicating the vehicle type class indicating the answer data included in the learning data is decreased. Through this process, the vehicle-type-estimation trained model is prepared.

The process of training the vehicle-type-estimation trained model may have been performed by another device or by the vehicle information estimator 35 in advance. When the process of training the vehicle-type-estimation trained model has been performed by another device in advance, the vehicle information estimator 35 acquires and stores the vehicle-type-estimation trained model from the other device.

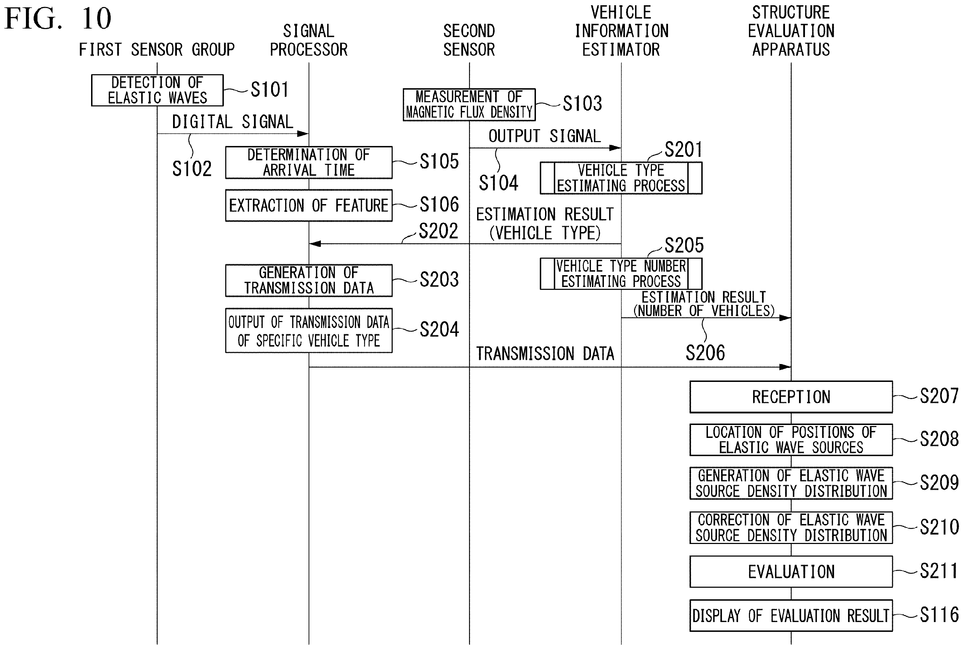

FIG. 10 is a sequence diagram illustrating a sequence of a process of evaluating a deterioration state which is performed by the structure evaluation system 100a according to the second embodiment. The sequence illustrated in FIG. 10 is performed when a vehicle 10 travels on the structure 50 to be evaluated. In FIG. 10, the same processes as illustrated in FIG. 6 will be referred to by the same reference signs and description thereof will be omitted. In FIG. 10, a plurality of first sensors 20 are referred to as a first sensor group.

When the output signal of the second sensor 25 is acquired in the process of Step S104, the vehicle information estimator 35a performs a vehicle type estimating process using the output signal of the second sensor 25 (Step S201). The vehicle type estimating process is a process of estimating a vehicle type of a vehicle 10 passing through an evaluation area in an evaluation period. The vehicle type estimating process will be described later. The vehicle information estimator 35a performs the vehicle type estimating process while the output signal of the second sensor 25 is being input. The vehicle information estimator 35a generates an estimation result including information of the vehicle type acquired through the vehicle type estimating process and the time information. The vehicle information estimator 35a outputs the generated estimation result to the signal processor 30a (Step S202). The vehicle information estimator 35a performs the process of Step S202 when a vehicle type is estimated through the vehicle type estimating process.

The transmission data generator 305 of the signal processor 30a generates transmission data including a sensor ID, time information, and parameters associated with features (Step S203). At this time, when an estimation result output from the vehicle information estimator 35a is acquired, the transmission data generator 305 compares time information included in the acquired estimation result with the time information included in the transmission data and determines whether an elastic wave arrival time indicated by the time information included in the transmission data is included in the range indicated by the time information included in the estimation result. When the elastic wave arrival time indicated by the time information included in the transmission data is included in the range indicated by the time information included in the estimation result, the transmission data generator 305 correlates vehicle type information of the vehicle 10 included in the estimation result with the transmission data. On the other hand, when an estimation result output from the vehicle information estimator 35a is not acquired, the transmission data generator 305 waits until an estimation result is acquired.

When a vehicle type indicated by the vehicle type information of the vehicle 10 correlated with the transmission data is a designated vehicle type, the transmission data generator 305 stores the generated transmission data in the memory 306. On the other hand, when a vehicle type indicated by the vehicle type information of the vehicle 10 correlated with the transmission data is not a designated vehicle type, the transmission data generator 305 discards the generated transmission data. When the vehicle type indicated by the vehicle type information of the vehicle 10 correlated with the transmission data is not a designated vehicle type, the transmission data generator 305 may store the generated transmission data in a memory other than the memory 306. When a plurality of first sensors 20 are connected to one signal processor 30a, digital signals based on elastic waves detected substantially at the same time are input to the signal processor 30a. The elastic waves detected substantially at the same time are elastic waves generated by the same type of vehicle 10. Therefore, the transmission data generator 305 considers the time information to be transmission data corresponding to the same vehicle type in a plurality of pieces of transmission data substantially at the same time (for example, within a predetermined range) and stores the plurality of pieces of transmission data in the memory 306.

The transmission data generator 305 performs the aforementioned process when a digital signal is input to the signal processor 30a. The signal processor 30a receives an estimation result indicating the vehicle type information as an input when the vehicle information estimator 35a performs the vehicle type estimating process. Therefore, when an estimation result is newly input, the transmission data generator 305 performs the aforementioned process on the basis of the newly input estimation result. The output 307 sequentially outputs the transmission data stored in the memory 306 to the structure evaluation apparatus 40. In this way, the signal processor 30a outputs the transmission data corresponding to a specific vehicle type to the structure evaluation apparatus 40 (Step S204).

For example, when only transmission data of a large vehicle is designated to be transmitted and a vehicle type indicated by the vehicle type information of the vehicle 10 correlated with the transmission data is a large vehicle, the transmission data generator 305 stores the generated transmission data in the memory 306. On the other hand, when a vehicle type indicated by the vehicle type information of the vehicle 10 correlated with the transmission data is not a large vehicle, the transmission data generator 305 discards the generated transmission data. The output 307 sequentially outputs the transmission data corresponding to a large vehicle stored in the memory 306 to the structure evaluation apparatus 40.

In the aforementioned example, the transmission data generator 305 filters the transmission data stored in the memory 306 on the basis of the vehicle type information of a vehicle 10 correlated with the transmission data. On the other hand, the output 307 may filter the transmission data to be output to the structure evaluation apparatus 40. In this case, the transmission data generator 305 stores all pieces of transmission data correlated with the vehicle type information of a vehicle 10 in the memory 306. The output 307 sequentially reads only transmission data correlated with designated vehicle type information out of a plurality of pieces of transmission data stored in the memory 306 from the memory 306 and outputs the read transmission data to the structure evaluation apparatus 40.

The vehicle information estimator 35a acquires an output signal output from the second sensor 25 in an evaluation period. The vehicle information estimator 35a performs a vehicle number estimating process using the acquired output signal corresponding to the evaluation period (Step S205). The vehicle number estimating process is the same as in the first embodiment. The vehicle information estimator 35a estimates passing vehicle number information as a result of the vehicle number estimating process. The vehicle information estimator 35a generates an estimation result indicating the estimated passing vehicle number information. The vehicle information estimator 35a outputs the generated estimation result to the structure evaluation apparatus 40 (Step S206).

The communicator 41 of the structure evaluation apparatus 40 receives the transmission data output from the signal processor 30a and the estimation result output from the vehicle information estimator 35a (Step S207). The acquirer 421 acquires the transmission data and the estimation result received by the communicator 41. The acquirer 421 records the acquired transmission data and the acquired estimation result in the storage 43. The acquirer 421 records all pieces of transmission data received in the evaluation period in the storage 43.

The event extractor 422 extracts transmission data in one event out of the transmission data corresponding to the evaluation period stored in the storage 43 after the evaluation period has elapsed or in response to an external instruction. The event extractor 422 outputs the extracted transmission data in one event to the position locator 423. The event extractor 422 performs the process of extracting transmission data in one event and the process of outputting the extracted transmission data in one event in a time series.

The position locator 423 locates a position of an elastic wave source on the basis of the sensor ID and the time information included in the transmission data output from the event extractor 422 and the sensor position information stored therein in advance (Step S208). The position of the elastic wave source located in the process of Step S208 is a position of a source of an elastic wave generated due to passage of a vehicle 10 of a designated vehicle type (for example, a large vehicle). That is, a position of a source of an elastic wave generated due to passage of a vehicle 10 of a non-designated vehicle type (for example, a regular vehicle) is not located.

The position locator 423 performs the process of Step S208 when transmission data in one event is output from the event extractor 422 in an evaluation period. Accordingly, the position locator 423 locates positions of a plurality of elastic wave sources generated in the evaluation period. The position locator 423 outputs position information of the plurality of elastic wave sources to the distribution generator 424.

The distribution generator 424 generates an elastic wave source distribution using the position information of the plurality of elastic wave sources output from the position locator 423. Specifically, the distribution generator 424 generates an elastic wave source distribution by plotting positions of the elastic wave sources indicated by the acquired position information of a plurality of elastic wave sources onto virtual data. The distribution generator 424 generates an elastic wave source density distribution using the generated elastic wave source distribution (Step S209). The distribution generator 424 outputs the generated elastic wave source density distribution to the corrector 425.

The corrector 425 receives the elastic wave source density distribution output from the distribution generator 424 and the estimation result stored in the storage 43 as inputs. The corrector 425 corrects the elastic wave source density distribution on the basis of the input elastic wave source density distribution and the input estimation result (Step S210). The corrector 425 outputs the corrected elastic wave source density distribution to the evaluator 426.

The evaluator 426 evaluates a deterioration state of the structure using the corrected elastic wave source density distribution (Step S211). The evaluator 426 outputs an evaluation result to the display 44. Thereafter, the process of Step S116 is performed.

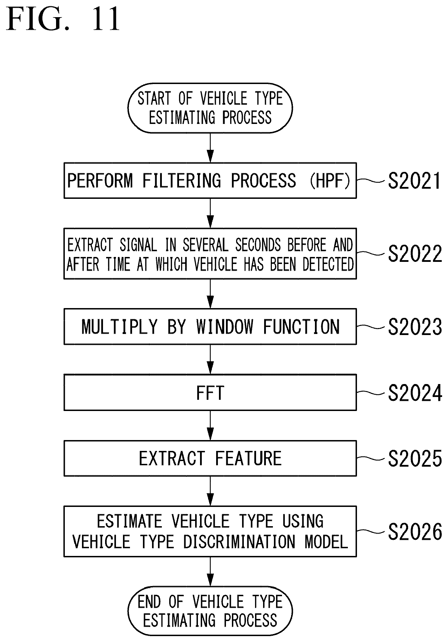

FIG. 11 is a flowchart illustrating a flow of the vehicle type estimating process which is performed by the vehicle information estimator 35a according to the second embodiment.

The vehicle information estimator 35a performs a filtering process on an output signal of the second sensor 25 (Step S2021). For example, the vehicle information estimator 35a performs a filtering process on the output signal of the second sensor 25 by causing the output signal to pass through a high-pass filter (for example, with a cut-off frequency of 1 Hz). Then, the vehicle information estimator 35a extracts a signal in a period within several seconds (for example, three seconds) before and after the timing at which a vehicle 10 has been detected from the output signal of the second sensor 25 (Step S2022). Here, the timing at which a vehicle 10 has been detected is an ascending timing of a waveform of the output signal of the second sensor 25.

The vehicle information estimator 35a multiplies the extracted signal by a window function (Step S2023). Thereafter, the vehicle information estimator 35a converts the signal to a signal in a frequency domain by performing fast Fourier transformation on the signal multiplied by the window function (Step S2024). The vehicle information estimator 35a extracts a feature using the signal in the frequency domain (Step S2025). For example, the vehicle information estimator 35a extracts at least one of maximum amplitude, energy (area), a sustainment time, a gravity center frequency, and a peak frequency of the output signal. The vehicle information estimator 35a estimates a vehicle type by inputting a value of the extracted feature or a value combined with one of the extracted feature as an explanatory variable to a vehicle-type-estimation trained model (Step S2026). For example, the vehicle information estimator 35a estimates a vehicle type by inputting a value of an energy/amplitude ratio and a value of gravity center frequency as explanatory variables $x_1$ and $x_2$ to the vehicle-type-estimation trained model.

The vehicle information estimator 35a estimates vehicle types of vehicles passing through an evaluation area in an evaluation period by performing the aforementioned process. The vehicle information estimator 35a includes at least a high-pass filter, an extractor, a window function multiplier, a Fourier transformation processor, a feature extractor, a vehicle-type-estimation trained model, and a vehicle type estimator as functions for estimating a vehicle type of a vehicle in addition to the function for estimating the number of vehicles.

With the structure evaluation system 100a having the aforementioned configuration, it is possible to achieve the same advantages as in the first embodiment.

In the structure evaluation system 100a, the signal processor 30a transmits only transmission data corresponding to a specific vehicle type to the structure evaluation apparatus 40 instead of transmitting all transmission data to the structure evaluation apparatus 40 as in the first embodiment. By performing this filtering, excitation conditions of elastic waves (for example, traveling vehicle conditions) can be made to be constant. As a result, it is possible to accurately evaluate a deterioration state.

(Modified example 1 of second embodiment)

Similarly to the first embodiment, the structure evaluation apparatus 40 may be configured to generate an elastic wave source density distribution in consideration of the passing vehicle number information estimated by the vehicle information estimator 35a in a step of generating the elastic wave source density distribution.

(Modified example 2 of second embodiment)

The vehicle information estimator 35a may be configured to estimate the number of vehicles 10 of a designated vehicle type out of vehicles 10 passing through an evaluation area in an evaluation period. In this case, the vehicle information estimator 35a outputs an estimation result indicating the number of vehicles 10 of the designated vehicle type passing through the evaluation area in the evaluation period to the structure evaluation apparatus 40.

(Third embodiment)

In a third embodiment, a configuration in which the vehicle information estimator estimates a vehicle type in addition to the number of vehicles on the basis of an output signal of the second sensor and the structure evaluation apparatus performs clustering based on the vehicle type and performs processing for each group will be described. Here, clustering based on a vehicle type means that data to be processed is divided into groups corresponding to vehicle types. The structure evaluation apparatus performs processing for each group using the grouped data.

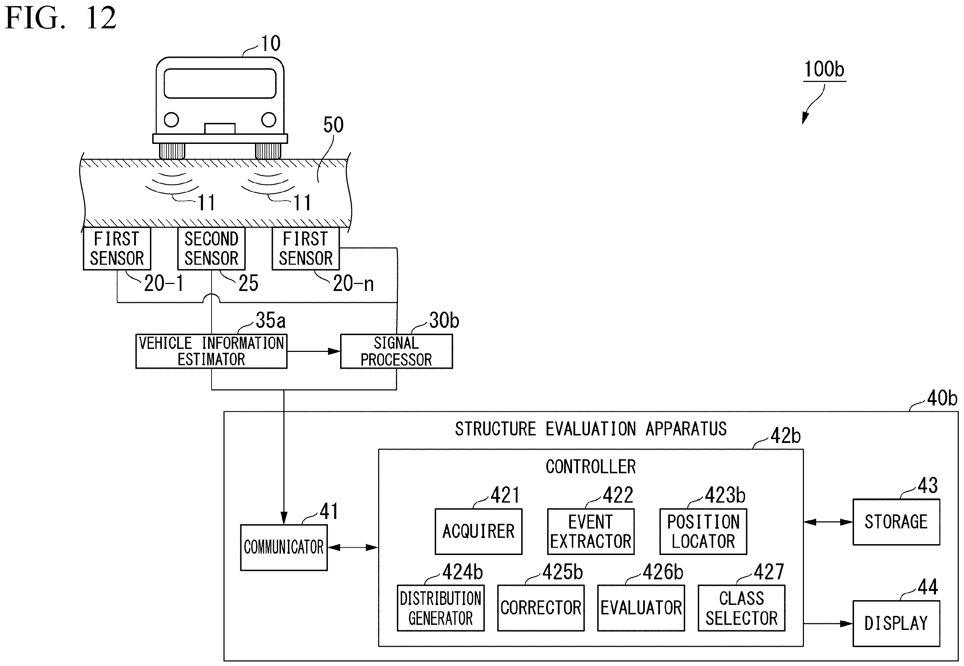

FIG. 12 is a diagram illustrating a configuration of a structure evaluation system 100b according to the third embodiment. The structure evaluation system 100b is used to evaluate soundness of a structure 50. The structure evaluation system 100b includes a plurality of first sensors 20-1 to 20-n, a second sensor 25, a signal processor 30b, a vehicle information estimator 35a, and a structure evaluation apparatus 40b. The plurality of first sensors 20-1 to 20-n and the signal processor 30b are communicatively connected to each other in a wired manner. The second sensor 25 and the vehicle information estimator 35a are communicatively connected to each other in a wired manner. The signal processor 30b and the vehicle information estimator 35a are communicatively connected to each other in a wired manner. The signal processor 30b and the structure evaluation apparatus 40b are communicatively connected to each other in a wired of wireless manner, and the vehicle information estimator 35a and the structure evaluation apparatus 40b are communicatively connected to each other in a wired or wireless manner.

The structure evaluation system 100b has a configuration different from that of the structure evaluation system 100a in that the signal processor 30b and the structure evaluation apparatus 40b are provided instead of the signal processor 30a and the structure evaluation apparatus 40. The structure evaluation system 100b has the same configuration as the structure evaluation system 100a in the other configuration. Differences from the structure evaluation system 100a will be mainly described below.

The signal processor 30b receives a digital signal output from an analog-digital converter and an estimation result output from the vehicle information estimator 35a as inputs. The signal processor 30b performs signal processing on the input digital signal. The signal processor 30b generates transmission data including the digital signal subjected to the signal processing. At this time, the signal processor 30b correlates the transmission data with vehicle type information indicated by the estimation result. In other words, the signal processor 30b adds vehicle type information indicated by the estimation result with the transmission data. The method of correlating the vehicle type information with the transmission data is the same as in the second embodiment and thus detailed description thereof will be omitted. Similarly to the second embodiment, the signal processor 30b may correlate the vehicle type information with the digital signal before the transmission data is generated. Accordingly, the signal processor 30b can correlate the vehicle type information of a vehicle 10 with the input digital signal at various timings. The signal processor 30b outputs all the transmission data correlated with the vehicle type information of a vehicle 10 to the structure evaluation apparatus 40b. Accordingly, the structure evaluation apparatus 40b having acquired the transmission data can discriminate to what vehicle type the received transmission data corresponds.

As described above, the signal processor 30b does not limit transmission data to be output to the structure evaluation apparatus 40b in comparison with the signal processor 30a according to the second embodiment. The signal processor 30a according to the second embodiment outputs only the transmission data corresponding to a designated vehicle type to the structure evaluation apparatus 40 as the transmission data to be output to the structure evaluation apparatus 40. On the other hand, the signal processor 30b outputs all the transmission data correlated with the vehicle type information of the vehicle 10 to the structure evaluation apparatus 40b. The transmission data output from the signal processor 30b means that a feature of an elastic wave is output. Similarly, a plurality of pieces of transmission data output from the signal processor 30b means that features of a plurality of elastic waves are output.

The signal processor 30b is constituted by an analog circuit or a digital circuit. The digital circuit is realized by, for example, an FPGA or a microcomputer. The digital circuit may be realized by a dedicated LSI. A nonvolatile memory such as a flash memory or a removable memory may be mounted in the signal processor 30b.

The structure evaluation apparatus 40b includes a communicator 41, a controller 42b, a storage 43, and a display 44. The controller 42b controls the structure evaluation apparatus 40b as a whole. The controller 42b is constituted by a processor such as a CPU and a memory. The controller 42b serves as an acquirer 421, an event extractor 422, a position locator 423b, a distribution generator 424b, a corrector 425b, an evaluator 426b, and a class selector 427 by executing a program.

Some or all of the functional units such as the acquirer 421, the event extractor 422, the position locator 423b, the distribution generator 424b, the corrector 425b, the evaluator 426b, and the class selector 427 may be realized by hardware such as ASIC, a PLD, or an FPGA or may be cooperatively realized by software and hardware. The program may be stored in a computer-readable recording medium. The computer-readable recording medium is, for example, a non-transitory storage medium such as a portable medium such as a flexible disk, a magneto-optical disc, a ROM, or a CD-ROM or a storage device such as a hard disk incorporated into a computer system. The program may be transmitted via a telecommunication line.

Some functional units such as the acquirer 421, the event extractor 422, the position locator 423b, the distribution generator 424b, the corrector 425b, the evaluator 426b, and the class selector 427 do not have to be mounted in the structure evaluation apparatus 40b in advance and may be realized by installing an additional application program in the structure evaluation apparatus 40b.

The position locator 423b locates positions of elastic wave sources on the basis of sensor position information and sensor IDs and time information included in a plurality of pieces of transmission data extracted by the event extractor 422. At this time, the position locator 423b acquires vehicle type information correlated with the plurality of pieces of transmission data used to locate the positions of elastic wave sources. The position locator 423b adds the acquired vehicle type information to the position information of the elastic wave sources acquired as a result of location. The position locator 423b outputs the position information of elastic wave sources to which the vehicle type information has been added to the distribution generator 424b. The position locator 423b adds the vehicle type information to the position information of elastic wave sources acquired in an evaluation period and outputs the resultant information to the distribution generator 424b.

The distribution generator 424b receives the position information of a plurality of elastic wave sources output from the position locator 423b as an input. The distribution generator 424b clusters the input position information of the plurality of elastic wave sources on the basis of the vehicle type information. For example, the distribution generator 424b clusters the input position information of the plurality of elastic wave sources into a large-vehicle group and a regular-vehicle group on the basis of the vehicle type information. The distribution generator 424b generates an elastic wave source distribution corresponding to the large-vehicle group using the position information of a plurality of elastic wave sources included in the large-vehicle group. Similarly, the distribution generator 424b generates an elastic wave source distribution corresponding to the regular-vehicle group using the position information of a plurality of elastic wave sources included in the regular-vehicle group. In this way, the distribution generator 424b generates an elastic wave source distribution for each class of vehicle types. The distribution generator 424b generates an elastic wave source density distribution for each class of vehicle types using the elastic wave source distribution for each class of vehicle types.

The corrector 425b corrects the elastic wave source density distribution for each class of vehicle types generated by the distribution generator 424b on the basis of the estimation result output from the vehicle information estimator 35. The corrector 425b may store the corrected elastic wave source density distribution for each class of vehicle types in the storage 43.

The evaluator 426b evaluates a deterioration state of the structure 50 using the corrected elastic wave source density distribution for each class of vehicle types. For example, the evaluator 426b may evaluate the deterioration state of the structure 50 using the corrected elastic wave source density distribution corresponding to the large-vehicle group or may evaluate the deterioration state of the structure 50 using the corrected elastic wave source density distribution corresponding to the regular-vehicle group.

The class selector 427 selects a specific class in accordance with an instruction which is externally input. The class selector 427 displays the corrected elastic wave source density distribution corresponding to the selected class on the display 44.

With the structure evaluation system 100b having the aforementioned configuration, it is possible to achieve the same advantages as in the first embodiment.

In the structure evaluation system 100b, the signal processor 30b transmits all the transmission data with vehicle type information added thereto to the structure evaluation apparatus 40b instead of transmitting the transmission data corresponding to a specific vehicle type to the structure evaluation apparatus 40 as in the second embodiment. Accordingly, the structure evaluation apparatus 40b can cluster the transmission data using the vehicle type information on the basis of the vehicle type information added to the transmission data and enable evaluation based on the transmission data for each vehicle type. As a result, it is possible to generate the elastic wave source density distribution for each excitation condition of elastic waves (for example, each traveling vehicle condition). It is possible to enable high-accuracy evaluation by selecting an appropriate class of vehicle types.

(Modified example 1 of third embodiment)

Similarly to the second embodiment, the structure evaluation apparatus 40b may be configured to generate an elastic wave source density distribution for each vehicle type in consideration of the passing vehicle number information estimated by the vehicle information estimator 35a in a step of generating the elastic wave source density distribution.

(Modified example 2 of third embodiment)

The vehicle information estimator 35a may be configured to estimate the number of vehicles 10 for each vehicle type out of vehicles 10 passing through an evaluation area in an evaluation period. In this case, the vehicle information estimator 35a outputs an estimation result indicating the number of vehicles 10 for each vehicle type passing through the evaluation area in the evaluation period to the structure evaluation apparatus 40b. The structure evaluation apparatus 40b corrects the elastic wave source density distribution using the estimated result indicating the number of vehicles 10 for each vehicle type. For example, the corrector 425b corrects the elastic wave source density distribution corresponding to a large vehicle generated by the distribution generator 424b on the basis of the number of large vehicles indicated by the estimation result output from the vehicle information estimator 35. For example, the corrector 425b corrects the elastic wave source density distribution corresponding to a regular vehicle generated by the distribution generator 424b on the basis of the number of regular vehicles indicated by the estimation result output from the vehicle information estimator 35.

(Modified example 1 common to embodiments)

The signal processor 30 or 30a and the vehicle information estimator 35 or 35a may be provided in the structure evaluation apparatus 40 or 40a. With this configuration, the structure evaluation apparatus 40 according to the first embodiment may include the signal processor 30 and the vehicle information estimator 35 instead of the communicator 41. The signal processor 30 outputs transmission data obtained by performing signal processing on elastic waves detected by the first sensors 20 to the controller 42. The vehicle information estimator 35 outputs the passing vehicle number information obtained on the basis of time-series data indicating change in a magnetic flux density detected by the second sensor 25 to the controller 42. The structure evaluation apparatus 40a according to the second embodiment may include the signal processor 30a and the vehicle information estimator 35a instead of the communicator 41. The signal processor 30a outputs designated transmission data out of transmission data obtained by performing signal processing on elastic waves detected by the first sensors 20 to the controller 42. The vehicle information estimator 35a outputs the passing vehicle number information obtained on the basis of time-series data indicating change in a magnetic flux density detected by the second sensor 25 to the controller 42 and outputs the vehicle type information obtained on the basis of the time-series data indicating change in a magnetic flux density to the signal processor 30a. The structure evaluation apparatus 40b according to the third embodiment may include the signal processor 30b and the vehicle information estimator 35a instead of the communicator 41. The signal processor 30b adds vehicle type information to transmission data obtained by performing signal processing on elastic waves detected by the first sensors 20 and outputs the resultant information to the controller 42b. The vehicle information estimator 35a outputs the passing vehicle number information obtained on the basis of time-series data indicating change in a magnetic flux density detected by the second sensor 25 to the controller 42b and outputs the vehicle type information obtained on the basis of the time-series data indicating change in a magnetic flux density to the signal processor 30b.

(Modified example 2 common to embodiments)

In the aforementioned embodiments, a plurality of first sensors 20-1 to 20-n are connected to a single signal processor 30, 30a, or 30b. The structure evaluation systems 100, 100a, and 100b may include a plurality of signal processors 30, 30a, and 30b, and the first sensors 20 may be connected to the different signal processors 30, 30a, and 30b.

(Modified example 3 common to embodiments)

Some or all of the functional units of the structure evaluation apparatus 40 or 40b may be provided in another device. For example, the display 44 of the structure evaluation apparatus 40 or 40b may be provided in another device. With this configuration, the structure evaluation apparatus 40 or 40b transmits an evaluation result to the other device including the display 44. The other device including the display 44 displays the received evaluation result.

(Modified example 4 common to embodiments)

The vehicle information estimator 35 or 35a may be configured to additionally estimate one of a vehicle length, a vehicle weight, a traveling lane, and a vehicle speed of a vehicle 10 as vehicle information. With this configuration, in the second embodiment, the signal processor 30a may perform filtering based on one of a vehicle type, a vehicle length, a vehicle weight, a lane, and a vehicle speed. Filtering based on a vehicle length means that transmission data other than the vehicle length in a specific range is not transmitted. The specific range of the vehicle length is a range equal to or less than A m (where A is an integer equal to or greater than 1), a range equal to or greater than A m, a range of A m to B m (where B is an integer equal to or greater than 2), or the like. Filtering based on a vehicle weight means that transmission data other than the vehicle weight in a specific range is not transmitted. The specific range of the vehicle weight is a range equal to or less than several hundreds of kg, a range equal to or greater than several hundreds of kg, a range of several hundreds of kg to several thousands of kg, or the like.

Filtering based on a lane means that transmission data other than a specific lane is not transmitted. The specific lane is a traveling lane, an overtake lane, or the like. Filtering based on a vehicle speed means that transmission data other than the vehicle speed in a specific range is not transmitted. The specific range of the vehicle speed is a range equal to or less than several tens of km/h, a range equal to or greater than several tens of km/h, a range of several tens of km/h to several tens of km/h, or the like. The specific operation is the same as filtering based on a vehicle type in the second embodiment, for example, where the vehicle type can be replaced with other vehicle information.

On the other hand, the vehicle information estimator 35a needs to store a trained model which is trained to output vehicle information to be estimated when the vehicle information is a vehicle length, a vehicle weight, a traveling lane, or a vehicle speed. For example, when the vehicle information estimator 35a estimates a vehicle length, the vehicle information estimator 35a needs to store a trained model which is trained to output information of the vehicle length with one or more features as an input. In case of other vehicle information, a trained model trained in this way needs to be stored. When a lane is estimated, amplitude of a detected signal differs between a traveling lane of a vehicle 10 and an overtake lane adjacent to the traveling lane. Therefore, a trained model for estimating a lane can be prepared by training a machine learning model with a feature associated with the amplitude as an input.

In the third embodiment, the vehicle information estimator 35a may discriminate one of a vehicle length, a vehicle weight, a lane, and a vehicle speed, and the structure evaluation apparatus 40b may perform clustering based on one of a vehicle length, a vehicle weight, a traveling lane, and a vehicle speed and perform processing for each group. Clustering based on a vehicle length means that data to be processed is classified into groups based on the vehicle length. For example, the groups include a group in which the vehicle length is less than A m and a group in which the vehicle length is equal to or greater than A m. Clustering based on a vehicle weight means that data to be processed is classified into groups based on the vehicle weight. For example, the groups include a group in which the vehicle weight is less than several hundreds of kg and a group in which the vehicle weight is equal to or greater than several hundreds of kg.

Clustering based on a lane means that data to be processed is classified into groups based on the lane. For example, the groups include a group of a traveling lane and a group of an overtaking lane. Clustering based on a vehicle speed means that data to be processed is classified into groups based on the vehicle speed. For example, the groups include a group in which the vehicle speed is less than several tens of km/h and a group in which the vehicle speed is equal to or greater than several tens of km/h. The specific operation is the same as clustering based on a vehicle type in the third embodiment.

(Vehicle speed estimating method)

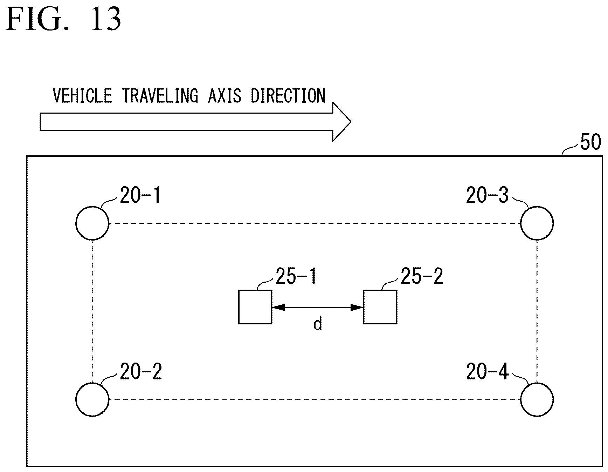

The vehicle speed estimating method will be described below with reference to FIG. 13. FIG. 13 is a diagram illustrating the vehicle speed estimating method. When a vehicle speed is estimated, two or more second sensors 25 are arranged in a vehicle traveling axis direction. In FIG. 13, for example, two second sensors 25-1 and 25-2 are arranged. An installation interval d between the second sensors 25-1 and 25-2 is known. When a vehicle 10 travels on the structure, the second sensors 25-1 and 25-2 detects the vehicle 10 on the basis of a time difference based on the vehicle speed. Specifically, the second sensor 25-2 detects the vehicle 10 when a certain time difference dt has elapsed after the second sensor 25-1 has detected the vehicle 10. The vehicle information estimator 35 or 35a estimates the vehicle speed V on the basis of Expression (4) using the time difference dt measured from a time difference between detection timings of output signals of the second sensors 25-1 and 25-2 and the known installation interval d.

$$V = \frac{d}{dt} \qquad \cdots (4)$$

According to at least one of the aforementioned embodiments, since a plurality of first sensors 20 that detect elastic waves generated from the inside of a structure 50 on which a vehicle 10 travels, one or more second sensors 25 that detect passage of the vehicle 10 without depending on damage in the structure 50, a vehicle information estimator 35 configured to estimate vehicle information including at least information of the number of vehicles 10 passing on the structure 50 on the basis of the one or more second sensors 25, and an evaluator 426 configured to evaluate a deterioration state of the structure 50 on the basis of a plurality of elastic waves detected by the plurality of first sensors 20 and the vehicle information estimated by the vehicle information estimator 35 are provided, it is possible to more accurately evaluate the deterioration state of the structure.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

**Claims**

1. A structure evaluation system comprising:

   a plurality of first sensors configured to detect elastic waves generated from the inside of a structure on which a vehicle travels;
   one or more second sensors configured to detect passage of the vehicle without depending on damage in the structure;
   a vehicle information estimator configured to estimate vehicle information including at least information of the number of vehicles passing on the structure on the basis of detection results from the one or more second sensors; and
   an evaluator configured to evaluate a deterioration state of the structure on the basis of the plurality of elastic waves detected by the plurality of first sensors and the vehicle information estimated by the vehicle information estimator.

2. The structure evaluation system according to claim 1,

   wherein the one or more second sensors are magnetic sensors configured to detect change in a magnetic flux density, and
   wherein the vehicle information estimator estimates the vehicle information on the basis of the change in the magnetic flux density detected by the one or more second sensors.

3. The structure evaluation system according to claim 1 or 2,
   wherein the vehicle information estimator estimates the number of vehicles passing on the structure by integrating peaks of output signals of the one or more second sensors.

4. The structure evaluation system according to claim 1 or 2,
   further comprising:

   a position locator configured to locate positions of sources of a plurality of elastic waves on the basis of the plurality of elastic waves detected by the plurality of first sensors;
   a distribution generator configured to generate an elastic wave source density distribution indicating a density distribution of positions of sources of the plurality of elastic waves on the basis of a location result from the position locator; and
   a corrector configured to correct the elastic wave source density distribution generated by the distribution generator on the basis of the vehicle information estimated by the vehicle information estimator,
   wherein the evaluator evaluates the deterioration state of the structure using the elastic wave source density distribution.

5. The structure evaluation system according to claim 4,
   wherein the corrector calculates a density in a predetermined range by dividing the number of elastic wave sources of which positions have been located in the predetermined range by an area of the predetermined range and corrects the elastic wave source density distribution by dividing the calculated density by the number of vehicles included in the vehicle information.

6. The structure evaluation system according to claim 1 or 2,
   further comprising:

   a position locator configured to locate positions of sources of a plurality of elastic waves on the basis of the plurality of elastic waves detected by the plurality of first sensors; and
   a density distribution generator configured to generate an elastic wave source density distribution indicating a density distribution of the positions of the sources of the plurality of elastic waves obtained on the basis of the vehicle information estimated by the vehicle information estimator and a location result from the position locator,
   wherein the evaluator evaluates the deterioration state of the structure using the elastic wave source density distribution.

7. The structure evaluation system according to claim 1 or 2,

   further comprising a signal processor configured to extract a feature of the plurality of elastic waves by performing signal processing on the plurality of elastic waves output from the plurality of first sensors,
   wherein the vehicle information estimator further estimates one of a vehicle type, a vehicle length, a vehicle weight, a traveling lane, and a vehicle speed of the vehicle as the vehicle information on the basis of output signals of the one or more second sensors and outputs the estimation result to the signal processor,
   wherein the signal processor identifies the extracted feature of the plurality of elastic waves on the basis of the estimation result output from the vehicle information estimator and outputs the identified feature of the plurality of elastic waves, and
   wherein the evaluator evaluates the deterioration state of the structure on the basis of the feature of the plurality of elastic waves output from the signal processor and the vehicle information estimated by the vehicle information estimator.

8. The structure evaluation system according to claim 7,
   wherein the vehicle information estimator classifies one of a vehicle type, a vehicle length, a vehicle weight, a traveling lane, and a vehicle speed of the vehicle into a plurality of classes using a trained model for classifying one of a vehicle type, a vehicle length, a vehicle weight, a traveling lane, and a vehicle speed of the vehicle into a plurality of classes with one or more of amplitude, sustainment time, envelope area, gravity center frequency, and maximum frequency out of features acquired from output signals of the one or more second sensors as an input.

9. The structure evaluation system according to claim 6,

   further comprising a signal processor configured to extract a feature of the plurality of elastic waves by performing signal processing on the plurality of elastic waves output from the plurality of first sensors,
wherein the vehicle information estimator further estimates one of a vehicle type, a vehicle length, a vehicle weight, a traveling lane, and a vehicle speed of the vehicle as the vehicle information on the basis of output signals of the one or more second sensors and outputs the estimation result to the signal processor,
wherein the signal processor adds the estimation result to the extracted feature of the plurality of elastic waves on the basis of the estimation result output from the vehicle information estimator and outputs the added feature, and
wherein the density distribution generator generates the elastic wave source density distribution for each class on the basis of the feature of the plurality of elastic waves output from the signal processor, the estimation result, and the vehicle information estimated by the vehicle information estimator.

10. The structure evaluation system according to claim 9,

further comprising a class selector configured to select a specific class in accordance with an instruction input from the outside,
wherein the class selector displays the elastic wave source density distribution corresponding to the selected class on a display.

11. The structure evaluation system according to claim 7,

wherein the one or more second sensors are a plurality of second sensors,
wherein the plurality of second sensors are arranged in a vehicle traveling axis direction, and
wherein the vehicle information estimator estimates a vehicle speed of the vehicle on the basis of a time difference between times at which passage of the vehicle has been detected by the plurality of second sensors.

12. The structure evaluation system according to claim 1 or 2,
wherein the one or more second sensors are provided in a range which is surrounded by the plurality of first sensors.

13. A structure evaluation method comprising:

estimating vehicle information including at least information of the number of vehicles passing on a structure on the basis of a sensing result from one or more second sensors detecting passage of a vehicle without depending on damage in the structure; and
evaluating a deterioration state of the structure on the basis of the plurality of elastic waves detected by a plurality of first sensors detecting elastic waves generated from a structure on which a vehicle travels and the estimated vehicle information.

FIG. 1

# FIG. 2

SIGNAL PROCESSOR

CLOCK

301 WAVEFORM SHAPING FILTER → 302 GATE GENERATION CIRCUIT → 303 ARRIVAL TIME DETERMINER → 305 TRANSMISSION DATA GENERATOR → 307 OUTPUT

304 FEATURE EXTRACTOR

306 MEMORY

30

EP 4 435 400 A1

# FIG. 3

# FIG. 4

FIG. 5

## FIG. 6

FIRST SENSOR GROUP | SIGNAL PROCESSOR | SECOND SENSOR | VEHICLE INFORMATION ESTIMATOR | STRUCTURE EVALUATION APPARATUS

DETECTION OF ELASTIC WAVES — S101

DIGITAL SIGNAL

S102

MEASUREMENT OF MAGNETIC FLUX DENSITY — S103

OUTPUT SIGNAL

DETERMINATION OF ARRIVAL TIME — S105

S104

S109

VEHICLE NUMBER ESTIMATING PROCESS

EXTRACTION OF FEATURE — S106

ESTIMATION RESULT (NUMBER OF VEHICLES)

GENERATION OF TRANSMISSION DATA — S107

TRANSMISSION DATA — S108   S110

RECEPTION — S111

LOCATION OF POSITIONS OF ELASTIC WAVE SOURCES — S112

GENERATION OF ELASTIC WAVE SOURCE DENSITY DISTRIBUTION — S113

CORRECTION OF ELASTIC WAVE SOURCE DENSITY DISTRIBUTION — S114

EVALUATION — S115

DISPLAY OF EVALUATION RESULT — S116

FIG. 7

(A) MAGNETIC FLUX DENSITY DETECTED ON BOTTOM SURFACE OF STRUCTURE
1500
1000
500
0
−500
−1000
−1500
TIME

(B) MAGNETIC FLUX DENSITY DETECTED ON BOTTOM SURFACE OF STRUCTURE
600
400
200
0
−200
−400
−600
TIME

(C) MAGNETIC FLUX DENSITY DETECTED ON BOTTOM SURFACE OF STRUCTURE
600
400
200
0
−200
−400
−600
TIME

(D) MAGNETIC FLUX DENSITY DETECTED ON BOTTOM SURFACE OF STRUCTURE
600
400
200
0
−200
−400
−600
TIME

(E) MAGNETIC FLUX DENSITY DETECTED ON BOTTOM SURFACE OF STRUCTURE
P
600
400
200
0
−200
−400
−600
TIME

FIG. 8

# FIG. 9

# FIG. 10

EP 4 435 400 A1

# FIG. 11

```
        ╭─────────────────────╮
        │  START OF VEHICLE TYPE │
        │   ESTIMATING PROCESS   │
        ╰─────────────────────╯
                  │
                  ▼
    ┌─────────────────────────────┐
    │ PERFORM FILTERING PROCESS (HPF) │──── S2021
    └─────────────────────────────┘
                  │
                  ▼
    ┌─────────────────────────────────────┐
    │ EXTRACT SIGNAL IN SEVERAL SECONDS BEFORE AND │──── S2022
    │ AFTER TIME AT WHICH VEHICLE HAS BEEN DETECTED │
    └─────────────────────────────────────┘
                  │
                  ▼
    ┌─────────────────────────────┐
    │   MULTIPLY BY WINDOW FUNCTION   │──── S2023
    └─────────────────────────────┘
                  │
                  ▼
    ┌─────────────────────────────┐
    │              FFT              │──── S2024
    └─────────────────────────────┘
                  │
                  ▼
    ┌─────────────────────────────┐
    │        EXTRACT FEATURE        │──── S2025
    └─────────────────────────────┘
                  │
                  ▼
    ┌─────────────────────────────┐
    │   ESTIMATE VEHICLE TYPE USING   │──── S2026
    │ VEHICLE TYPE DISCRIMINATION MODEL │
    └─────────────────────────────┘
                  │
                  ▼
        ╭─────────────────────╮
        │   END OF VEHICLE TYPE  │
        │   ESTIMATING PROCESS   │
        ╰─────────────────────╯
```

FIG. 12

FIG. 13

VEHICLE TRAVELING AXIS DIRECTION

Europäisches
Patentamt

European
Patent Office

Office européen
des brevets

# EUROPEAN SEARCH REPORT

**Application Number**

EP 23 19 3871

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2020/217822 A1 (SOMEDA KEIICHIRO [JP] ET AL) 9 July 2020 (2020-07-09) | 1-3, 11-13 | INV.<br>G01M5/00 |
| A | * paragraph [0002] – paragraph [0003]; figures 1,5-15 *<br>* paragraph [0031] – paragraph [0036] *<br>* paragraph [0053] – paragraph [0150] * | 4-10 | G08G1/00 |
| X | US 2022/187253 A1 (TAKAMINE HIDEFUMI [JP] ET AL) 16 June 2022 (2022-06-16)<br>* paragraph [0002] *<br>* paragraph [0017] – paragraph [0105]; figures 1-8 * | 1-13 | |
| A | US 2022/130240 A1 (TAKAMINE HIDEFUMI [JP] ET AL) 28 April 2022 (2022-04-28)<br>* paragraph [0002] *<br>* paragraph [0019] – paragraph [0030]; figures 1-2 *<br>* paragraph [0075] – paragraph [0107]; figures 9-11 * | 1-13 | |
| A | US 2021/350699 A1 (LI CHANGLE [CN] ET AL) 11 November 2021 (2021-11-11)<br>* paragraph [0001] – paragraph [0004]; figures 1-5 *<br>* paragraph [0047] – paragraph [0084] * | 1-13 | TECHNICAL FIELDS SEARCHED (IPC)<br><br>G01M<br>G08G<br>G01N<br>E01D |
| A | US 6 208 268 B1 (SCARZELLO JOHN F [US] ET AL) 27 March 2001 (2001-03-27)<br>* claims 1,2; figure 1 * | 1-13 | |

The present search report has been drawn up for all claims

| Place of search | Date of completion of the search | Examiner |
|---|---|---|
| The Hague | 24 January 2024 | Foster, Keir |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
...........................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

**EP 23 19 3871**

This annex lists the patent family members relating to the patent documents cited in the above-mentioned European search report.
The members are as contained in the European Patent Office EDP file on
The European Patent Office is in no way liable for these particulars which are merely given for the purpose of information.

**24-01-2024**

| Patent document cited in search report | | Publication date | Patent family member(s) | | Publication date |
|---|---|---|---|---|---|
| US 2020217822 | A1 | 09-07-2020 | JP | 7160695 B2 | 25-10-2022 |
| | | | JP | 2020112396 A | 27-07-2020 |
| | | | JP | 2022191400 A | 27-12-2022 |
| | | | US | 2020217822 A1 | 09-07-2020 |
| US 2022187253 | A1 | 16-06-2022 | EP | 4184161 A1 | 24-05-2023 |
| | | | JP | 7323698 B2 | 08-08-2023 |
| | | | JP | WO2022014004 A1 | 20-01-2022 |
| | | | US | 2022187253 A1 | 16-06-2022 |
| | | | WO | 2022014004 A1 | 20-01-2022 |
| US 2022130240 | A1 | 28-04-2022 | CN | 114487126 A | 13-05-2022 |
| | | | EP | 3992939 A1 | 04-05-2022 |
| | | | JP | 2022070711 A | 13-05-2022 |
| | | | US | 2022130240 A1 | 28-04-2022 |
| US 2021350699 | A1 | 11-11-2021 | CN | 111524365 A | 11-08-2020 |
| | | | US | 2021350699 A1 | 11-11-2021 |
| | | | ZA | 202102567 B | 30-03-2022 |
| US 6208268 | B1 | 27-03-2001 | NONE | | |

EPO FORM P0459

For more details about this annex : see Official Journal of the European Patent Office, No. 12/82